(19) Europäisches Patentamt / European Patent Office / Office européen des brevets

(11) **EP 3 289 007 B1**

(12) **EUROPEAN PATENT SPECIFICATION**

(45) Date of publication and mention of the grant of the patent:
**25.12.2024 Bulletin 2024/52**

(21) Application number: **16728427.2**

(22) Date of filing: **29.04.2016**

(51) International Patent Classification (IPC):
**C08J 7/12** (2006.01)

(52) Cooperative Patent Classification (CPC):
**C08J 7/123; C08J 2323/12**

(86) International application number:
**PCT/US2016/030065**

(87) International publication number:
**WO 2016/176561 (03.11.2016 Gazette 2016/44)**

(54) **PLASMA TREATMENT WITH NON-POLYMERIZING COMPOUNDS THAT LEADS TO REDUCED DILUTE BIOMOLECULE ADHESION TO THERMOPLASTIC ARTICLES**

PLASMABEHANDLUNG MIT NICHTPOLYMERISIERENDEN VERBINDUNGEN, DIE ZU REDUZIERTER HAFTUNG VON VERDÜNNTEM BIOMOLEKÜL AN THERMOPLASTISCHE ARTIKEL FÜHRT

TRAITEMENT AU PLASMA AVEC DES COMPOSÉS NON POLYMÉRISANTS QUI CONDUIT À LA RÉDUCTION DE L'ADHÉRENCE DE BIOMOLÉCULES À DES ARTICLES THERMOPLASTIQUES

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **30.04.2015 US 201562155090 P**
**19.10.2015 US 201562243392 P**

(43) Date of publication of application:
**07.03.2018 Bulletin 2018/10**

(73) Proprietor: **Si02 Medical Products, Inc.**
**Auburn, AL 36832 (US)**

(72) Inventors:
• **TAHA, Ahmad**
**Auburn, Alabama 36830 (US)**
• **FELTS, John T.**
**Alameda, California 94501 (US)**

(74) Representative: **Maiwald GmbH**
**Elisenhof**
**Elisenstraße 3**
**80335 München (DE)**

(56) References cited:
EP-A1- 1 689 216     WO-A1-96/23834
US-A- 5 147 678     US-A- 5 369 012
US-A1- 2013 022 752

**Description**

FIELD OF INVENTION

The invention relates generally to treating a surface of a plastic substrate to reduce biomolecule adhesion to the surface. More particularly, the invention relates to plasma treatment or surface modification of a plastic substrate, e.g., a medical device or item of laboratory ware, using non-polymerizing compounds to reduce protein adhesion to the substrate surface.

BACKGROUND

In blood, biomolecule, and blood analyte testing, it is desirable to minimize biomolecule adsorption and binding to plastic ware used with these biological substances. Plastic microwell plates, chromatography vials, and other containers, as well as pipettes (sometimes spelled "pipets"), pipette tips, centrifuge tubes, microscope slides, and other types of laboratory ware (also known as labware) used to prepare and transfer samples commonly have hydrophobic surfaces and readily adsorb biomolecules such as proteins, DNA, and RNA. Surfaces of these and other types of laboratory ware components made of polymeric plastic can cause binding of the biomolecule samples. It is thus a desire to provide surfaces for plastic laboratory ware and other articles that contact biological substances, to reduce a wide range of biomolecules from adhering.

US 5,369,012 A describes that a portion of an organic polymer article is made hydrophilic by exposing a hydrophobic surface of the article to a depth of about 50 to about 5000 angstroms to atomic oxygen or hydroxyl radicals at a temperature below 100°C to form a hydrophilic uniform surface layer of hydrophilic hydroxyl groups. The atomic oxygen and hydroxyl radicals are generated by a flowing afterglow microwave discharge, and the surface is outside of a plasma produced by the discharge. According to US 5,369,012 A, such membrane having both hydrophilic and hydrophobic surfaces can be used in an immunoassay or in cell culturing; prior to adhering cells, the hydrophilic surface may be grafted with a compatibilizing compound.

SUMMARY

The invention is set out in the appended claims. In one aspect, the invention pertains to a method for treating a surface of a plastic substrate. The method comprises:

optionally, a conditioning plasma treatment carried out by treating a surface of a plastic substrate with conditioning plasma of one or more non-polymerizing compounds generated at a remote point from the surface, where the ratio of the radiant energy density at the remote point to the radiant energy density at the brightest point of the conditioning plasma is less than 0.5, optionally less than 0.25, forming a conditioned surface; and

a conversion plasma treatment carried out by treating the conditioned surface (if the optional step is performed) or unconditioned surface (if the optional step is omitted) with conversion plasma of water vapor, the conversion plasma being generated at a remote point from the conditioned surface, where the ratio of the radiant energy density at the remote point of conversion plasma treatment to the radiant energy density at the brightest point of the conversion plasma is less than 0.5, optionally less than 0.25, wherein the radiant energy density at the brightest point of the plasma is determined spectrophotometrically by measuring the radiant intensity of the most intense emission line of light in the spectrum from 380 nm to 750 nm wavelength at the brightest point, and the radiant energy density at the remote point is determined spectrophotometrically by measuring the radiant energy density of the same emission line of light at the remote point,

to form a converted surface having a biomolecule recovery percentage, for an aqueous protein dispersion having a concentration from 0.01 nM to 1.4 nM, optionally 0.05 nM to 1.4 nM, optionally 0.1 nM to 1.4 nM, in contact with the converted surface, greater than 80%.

In a more detailed embodiment, the method includes at least two treatment steps. The conditioning step includes conditioning the surface with remote conditioning plasma of one or more non-polymerizing compounds, forming a conditioned surface. The conversion step includes converting the conditioned surface with remote conversion plasma of water to form a converted surface. The converted surface has a biomolecule recovery percentage greater than the biomolecule recovery percentage of the surface prior to treatment according to the method.

In another aspect, the invention pertains to an article resulting from the method according to the invention.

BRIEF DESCRIPTION OF THE DRAWINGS

The invention will be described in conjunction with the following drawings in which like reference numerals designate like elements and in which:

FIG.1 illustrates a generically described remote conversion plasma treatment apparatus useful in the invention, certain features of which are optional.

FIG. 2 illustrates an exemplary plasma reactor configuration for carrying out remote conversion plasma treatment of microplates according to the more detailed embodiment.

FIG. 3 is a bar graph illustrating comparative biomolecule recovery results between unconditioned and unconverted polypropylene microplates, Eppendorf brand microplates and microplates treated with an exemplary remote conversion plasma treatment process according to the more detailed embodiment.

FIG. 4 is a bar graph illustrating comparative biomolecule recovery results between microplates treated with an exemplary remote conversion plasma treatment process according to the more detailed embodiment and microplates treated with the same process steps and conditions except using direct conversion plasma treatment instead of remote conversion plasma treatment.

FIG. 5 is a bar graph illustrating comparative biomolecule recovery results between microplates treated with an exemplary remote conversion plasma treatment process according to the more detailed embodiment and microplates treated with only the non-polymerizing compound step and without the second step.

FIG. 6 illustrates an exemplary radio-frequency-excited plasma reactor configuration according to FIG. 1 for carrying out remote conversion plasma treatment of microplates according to the more detailed embodiment.

FIG. 7 illustrates another exemplary plasma reactor configuration according to FIG. 1 for carrying out remote conversion plasma treatment of microplates according to the more detailed embodiment.

FIG. 8 is an exemplary microwave-excited plasma reactor configuration according to FIG. 1 for carrying out remote conversion plasma treatment of microplates according to the more detailed embodiment.

FIG. 9 is a plot of biomolecule (TFN) recovery from unconditioned and unconverted polypropylene beakers, treated polypropylene beakers according to the more detailed embodiment, and glass beakers.

FIG. 10 shows an exemplary reactor configuration for carrying out the present invention. Another suitable reactor configuration is that of Figure 2 as shown and described in U.S. Pat. No. 7,985,188.

FIG. 11 is a plot of protein recovery versus concentration of protein (BSA) for Example 6.

FIG. 12 is a plot of protein recovery versus concentration of protein (PrA) for Example 6.

FIG. 13 is a plot of protein recovery versus concentration of protein (PrG) for Example 6.

FIG. 14 is a plot of protein recovery versus concentration of protein (BSA) for Example 14.

FIG. 15 is a plot of protein recovery versus concentration of protein (PrA) for Example 14.

FIG. 16 is a plot of protein recovery versus concentration of protein (PrG) for Example 14.

FIG. 17 is a GC-MS (gas chromatography - mass spectroscopy) plot characterizing extracted organic species from low protein binding treated microplates according to Example 15, showing peak assignments.

FIG. 18 is a plot similar to FIG. 17 for an isopropanol blank according to Example 15.

FIG. 19 is a plot similar to FIG. 17 from Example 15 without peak assignments, for comparison with FIG. 18.

FIG. 20 is a comparison from Example 16 of the LC-MS isopropanol extracted ion chromatogram (positive APCI mode) of the $SiO_2$ low protein binding treated plates (lower plot) vs that of the isopropanol blank (upper plot).

FIG. 21 is a comparison from Example 16 of the LC-MS isopropanol extracted ion chromatogram (positive APCI mode) of the $SiO_2$ unconditioned and unconverted plates (lower plot) vs that of the isopropanol blank (upper plot), showing the presence of a polypropylene component in the unconditioned and unconverted plate extract.

FIG. 22 is a comparison from Example 16 of the LC-MS isopropanol extracted ion chromatogram (negative APCI mode) of the $SiO_2$ low protein binding treated plates (lower plot) vs that of the isopropanol blank (upper plot).

The following reference characters are used in this description and the accompanying Figures:

| 9 | Apparatus | | 36 | Treated polypropylene plot |
|---|---|---|---|---|
| 10 | Treatment volume | | 38 | Glass plot |
| 11 | Reaction chamber wall (optional) | | 110 | Chamber |
| 12 | Fluid source | | 112 | Bottom (of 110) |
| 13 | Fluid inlet | | 114 | Lid (of 110) |
| 14 | Substrate | | 116 | Vacuum conduit |
| 15 | Plasma zone | | 118 | Vacuum pump |
| 16 | Shield (optional) | | 120 | Valve |
| 17 | Treatment gas | | 122 | Gas inlet |
| 18 | Plasma energy source | | 124 | Processing area |
| 19 | Lid (optional) | | 126 | Gas system |
| 20 | Plasma (boundary) | | 128 | Mass flow controller |
| 21 | Substrate support (optional) | | 130 | Compressed gas source |
| 22 | Vacuum source (optional) | | 132 | Capillary |
| 23 | Applicator | | 134 | Manifold |
| 24 | Remote conversion plasma | | 136 | Shut-off valve |
| 26 | Flat spot (of 20) (optional) | | 138 | Electrode |
| 28 | Front surface (of 14) | | 140 | Matching network |
| 30 | Back surface (of 14) | | 142 | RF power supply |
| 32 | Well (of 14) (optional) | | 144 | Coaxial cable |
| 34 | Unconditioned and unconverted polypropylene plot | | 150 | FIG. 14 - BSA-EPP Plot |
| | | | 152 | FIG. 14 - BSA- SiO2 Plot |
| 154 | FIG. 15 - PrA-SiO2 Plot |
| 156 | FIG. 15 - PrA-EPP Plot |
| 158 | FIG. 16 - PrG-SiO2 Plot |
| 160 | FIG. 16 - PrG-EPP Plot |

## DETAILED DESCRIPTION OF THE PREFERRED EMBODIMENTS

According to the invention, methods are disclosed for reducing biomolecule adhesion to a surface. A method for treating a surface, optionally an entire or partial surface of a substrate or a surface of a material, is provided, most generally comprising treating the surface with conversion plasma of one or more non-polymerizing compounds to form a treated surface.

The term "biomolecule" is used respecting any embodiment to include any nucleotides or peptides, or any combination of them. Nucleotides include oligonucleotides and polynucleotides, also known as nucleic acids, for example deoxyribonucleic acid (DNA) and ribonucleic acid (RNA). Peptides include amino acids, oligopeptides, polypeptides, and proteins. Nucleotides and peptides further include modified or derivatized nucleotides and peptides that adhere to a surface that is not treated according to the present invention.

The presently defined biomolecules include to one or more of the following aqueous proteins: mammal serum albumin, for example Bovine Serum Albumin (BSA); Fibrinogen (FBG); Transferrin (TFN), for example blood serotransferrin (or siderophilin, also known as transferrin); lactotransferrin (lactoferrin); milk transferrin; egg white ovotransferrin (conalbumin); membrane-associated melanotransferrin; Protein A (PrA); Protein G (PrG); Protein A/G; Protein L; Insulin, for example hexameric insulin, monomeric insulin, porcine insulin, human insulin, recombinant insulin and pharmaceutical grades of insulin; pharmaceutical protein; blood or blood component proteins; or any recombinant form, modification, full length precursor, signal peptide, pro-peptide, or mature variant of these proteins; and a combination of two or more of these.

Biomolecule adhesion to a surface is defined for any embodiment as a reduction of the aqueous concentration of a biomolecule dispersed in an aqueous medium stored in contact with the surface. It is not limited by the mechanism of reduction of concentration, whether literally "adhesion," adsorption, or another mechanism.

"Plasma," as referenced in any embodiment, has its conventional meaning in physics of one of the four fundamental states of matter, characterized by extensive ionization of its constituent particles, a generally gaseous form, and incandescence (i.e. it produces a glow discharge, meaning that it emits light).

"Conversion plasma treatment" refers to any plasma treatment that reduces the adhesion of one or more biomolecules to a treated surface.

"Conditioning plasma treatment" refers to any plasma treatment of a surface to prepare the surface for further conversion plasma treatment. "Conditioning plasma treatment" includes a plasma treatment that, in itself, reduces the adhesion of one or more biomolecules to a treated surface, but is followed by conversion plasma treatment that further reduces the adhesion of one or more biomolecules to a treated surface. "Conditioning plasma treatment" also includes a plasma treatment that, in itself, does not reduce the adhesion of one or more biomolecules to a treated surface.

A "remote" conversion plasma treatment, generally speaking, is conversion plasma treatment of a surface located at a "remote" point where the radiant energy density of the plasma, for example in Joules per $cm^3$, is substantially less than the maximum radiant energy density at any point of the plasma glow discharge (referred to below as the "brightest point"), but the remote surface is close enough to some part of the glow discharge to reduce the adhesion of one or more biomolecules to the treated remote surface. "Remote" is defined in the same manner respecting a remote conditioning plasma treatment, except that the remote surface must be close enough to some part of the glow discharge to condition the surface.

The radiant energy density at the brightest point of the plasma is determined spectrophotometrically by measuring the radiant intensity of the most intense emission line of light in the visible spectrum (380 nanometer (nm) to 750 nm wavelength) at the brightest point. The radiant energy density at the remote point is determined spectrophotometrically by measuring the radiant energy density of the same emission line of light at the remote point. "Remoteness" of a point is quantified by measuring the ratio of the radiant energy density at the remote point to the radiant energy density at the brightest point. The present specification and claims define "remote" quantitatively as a specific range of that ratio. Broadly, the ratio is from 0 to less than 0.5, optionally from 0 to 0.25, optionally about 0, optionally exactly 0. Remote conversion plasma treatment can be carried out where the ratio is zero, even though that indicates no measurable visible light at the remote point, because the dark discharge region or afterglow region of plasma contain energetic species that, although not energetic enough to emit light, are energetic enough to modify the treated surface to reduce the adhesion of one or more biomolecules.

A "non-polymerizing compound" is defined operationally for all embodiments as a compound that does not polymerize on a treated surface or otherwise form an additive coating under the conditions used in a particular plasma treatment of the surface. Examples of compounds that can be used under non-polymerizing conditions are the following: $O_2$, $N_2$, air, $O_3$, $N_2O$, $H_2$, $H_2O_2$, $NH_3$, Ar, He, Ne, and combinations of any of two or more of the foregoing. These may also include alcohols, organic acids, and polar organic solvents as well as materials that can be polymerized under different plasma conditions from those employed. "Non-polymerizing" includes compounds that react with and bond to a preexisting polymeric surface and locally modify its composition at the surface. The essential characterizing feature of a non-polymerizing coating is that it does not build up thickness (i.e. build up an additive coating) as the treatment time is increased.

A "substrate" is an article or other solid form (such as a granule, bead, or particle).

A "surface" is broadly defined as either an original surface (a "surface" also includes a portion of a surface wherever used in this specification) of a substrate, or a coated or treated surface prepared by any suitable coating or treating method, such as liquid application, condensation from a gas, or chemical vapor deposition, including plasma enhanced chemical vapor deposition carried out under conditions effective to form a coating on the substrate.

A treated surface is defined for all embodiments as a surface that has been plasma treated as described in this specification.

The terms "optionally" and "alternatively" are regarded as having the same meaning in the present specification and claims, and may be used interchangeably.

The "material" in any embodiment can be any material of which a plastic substrate is formed, including a thermoplastic material, optionally a thermoplastic injection moldable material. The substrate according to any embodiment may be made, for example, from material including: an olefin polymer; polypropylene (PP); polyethylene (PE); cyclic olefin copolymer (COC); cyclic olefin polymer (COP); polymethylpentene; polyester; polyethylene terephthalate; polyethylene naphthalate; polybutylene terephthalate (PBT); PVdC (polyvinylidene chloride); polyvinyl chloride (PVC); polycarbonate; polymethylmethacrylate; polylactic acid; polylactic acid; polystyrene; hydrogenated polystyrene; poly(cyclohexylethylene) (PCHE); epoxy resin; nylon; polyurethane polyacrylonitrile; polyacrylonitrile (PAN); an ionomeric resin; or Surlyn® ionomeric resin.

The term "vessel" as used throughout this specification may be any type of article that is adapted to contain or convey a liquid, a gas, a solid, or any two or more of these. One example of a vessel is an article with at least one opening (e.g., one, two or more, depending on the application) and a wall defining an interior contacting surface.

A wide variety of different surfaces can be treated according to any embodiment. One example of a surface is a vessel lumen surface, where the vessel is, for example, a vial, a bottle, a jar, a syringe, a cartridge, a blister package, or an ampoule. For more examples, the surface of the material can be a fluid surface of an article of labware, for example a microplate, a centrifuge tube, a pipette tip, a well plate, a microwell plate, an ELISA plate, a microtiter plate, a 96-well plate, a 384-well plate, a centrifuge tube, a chromatography vial, an evacuated blood collection tube, or a specimen tube.

The treated surface of any embodiment can be a coating or layer of PECVD deposited $SiO_xC_yH_z$ or $SiN_xC_yH_z$, in which x is from about 0.5 to about 2.4 as measured by X-ray photoelectron spectroscopy (XPS), y is from about 0.6 to about 3 as measured by XPS, and z is from about 2 to about 9 as measured by Rutherford backscattering spectrometry (RBS). Another example of the surface to be treated is a barrier coating or layer of $SiO_x$, in which x is from about 1.5 to about 2.9 as measured by XPS, or an oxide or nitride of an organometallic precursor that is a compound of a metal element from Group III and/or Group IV of the Periodic Table, e.g. in Group III: Boron, Aluminum, Gallium, Indium, Thallium, Scandium, Yttrium, or Lanthanum, (Aluminum and Boron being preferred), and in Group IV: Silicon, Germanium, Tin, Lead, Titanium, Zirconium, Hafnium, or Thorium (Silicon and Tin being preferred).

A gas or gases employed to treat a surface can be an inert gas or a reactive gas, and can be any of the following: $O_2$, $N_2$, air, $O_3$, $N_2O$, $NO_2$, $N_2O_4$, $H_2$, $H_2O_2$, $H_2O$, $NH_3$, Ar, He, Ne, Xe, Kr, a nitrogen-containing gas, other non-polymerizing gases, gas combinations including an $Ar/O_2$ mix, an $N_2/O_2$ mix following a pre-treatment conditioning step with Ar, a volatile and polar organic compound, the combination of a $C_1$-$C_{12}$ hydrocarbon and oxygen; the combination of a $Ci$-$C_{12}$ hydrocarbon and nitrogen; a silicon-containing gas; or a combination of two or more of these. The treatment employs a non-polymerizing gas as defined in this specification.

A volatile and polar organic compound can be, for example water, for example tap water, distilled water, or deionized water; an alcohol, for example a $C_1$-$C_{12}$ alcohol, methanol, ethanol, n-propanol, isopropanol, n-butanol, isobutanol, s-butanol, t-butanol; a glycol, for example ethylene glycol, propylene glycol, butylene glycol, polyethylene glycol, and others; glycerine, a $C_1$-$C_{12}$ linear or cyclic ether, for example dimethyl ether, diethyl ether, dipropyl ether, dibutyl ether, glyme ($CH_3OCH_2CH_2OCH_3$); cyclic ethers of formula $-CH_2CH_2O_n-$ such as diethylene oxide, triethylene oxide, and tetraethylene oxide; cyclic amines; cyclic esters (lactones), for example acetolactone, propiolactone, butyrolactone, valerolactone, and caprolactone; a $C_1$-$C_{12}$ aldehyde, for example formaldehyde, acetaldehyde, propionaldehyde, or butyraldehyde; a $C_1$-$C_{12}$ ketone, for example acetone, diethylketone, dipropylketone, or dibutylketone; a $C_1$-$C_{12}$ carboxylic acid, for example formic acid, acetic acid, propionic acid, or butyric acid; ammonia, a $C_1$-$C_{12}$ amine, for example methylamine, dimethylamine, ethylamine, diethylamine, propylamine, butylamine, pentylamine, hexylamine, heptylamine, octylamine, nonylamine, decylamine, undecylamine, or dodecylamine; hydrogen fluoride, hydrogen chloride, a $C_1$-$C_{12}$ epoxide, for example ethylene oxide or propylene oxide; or a combination of any two or more of these.

A $C_1$-$C_{12}$ hydrocarbon can be methane, ethane, ethylene, acetylene, n-propane, i-propane, propene, propyne; n-butane, i-butane, t-butane, butane, 1-butyne, 2-butyne, or a combination of any two or more of these.

A silicon-containing gas can be a silane, an organosilicon precursor, or a combination of any two or more of these. The silicon-containing gas can be an acyclic or cyclic, substituted or unsubstituted silane, optionally comprising, consisting essentially of, or consisting of any one or more of: $Si_1$-$Si_4$ substituted or unsubstituted silanes, for example silane, disilane, trisilane, or tetrasilane; hydrocarbon or halogen substituted $Si_1$-$Si_4$ silanes, for example tetramethylsilane (TetraMS), tetraethyl silane, tetrapropylsilane, tetrabutylsilane, trimethylsilane (TriMS), triethyl silane, tripropylsilane, tributylsilane, trimethoxysilane, a fluorinated silane such as hexafluorodisilane, a cyclic silane such as octamethylcyclotetrasilane or tetramethylcyclotetrasilane, or a combination of any two or more of these. The silicon-containing gas can be a linear siloxane, a monocyclic siloxane, a polycyclic siloxane, a polysilsesquioxane, an alkyl trimethoxysilane, a linear silazane, a monocyclic silazane, a polycyclic silazane, a polysilsesquiazane, or a combination of any two or more of these, for example hexamethyldisiloxane (HMDSO), tetramethyldisiloxane (TMDSO), octamethylcyclotetrasiloxane (OMCTS), tetramethyldisilazane, hexamethyldisilazane, octamethyltrisilazane, octamethylcyclotetrasilazane, tetramethylcyclotetrasilazane, or a combination of any two or more of these.

The electrical power used to excite the plasma used in plasma treatment in any embodiment, can be, for example, from 1 to 1000 Watts, optionally from 100 to 900 Watts, optionally from 50 to 600 Watts, optionally 100 to 500 Watts, optionally from 500 to 700 Watts, optionally from 1 to 100 Watts, optionally from 1 to 30 Watts, optionally from 1 to 10 Watts, optionally from 1 to 5 Watts.

The frequency of the electrical power used to excite the plasma used in plasma treatment, in any embodiment, can be any type of energy that will ignite plasma in the plasma zone. For example, it can be direct current (DC) or alternating current (electromagnetic energy) having a frequency from 3 Hz to 300GHz. Electromagnetic energy in this range generally includes radio frequency (RF) energy and microwave energy, more particularly characterized as extremely low frequency (ELF) of 3 to 30 Hz, super low frequency (SLF) of 30 to 300 Hz, voice or ultra-low frequency (VF or ULF) of 300 Hz to 3kHz, very low frequency (VLF) of 3 to 30 kHz, low frequency (LF) of 30 to 300 kHz, medium frequency (MF) of 300 kHz to 3 MHz, high frequency (HF) of 3 to 30 MHz, very high frequency (VHF) of 30 to 300 MHz, ultra-high frequency (UHF) of 300 MHz to 3 GHz, super high frequency (SHF) of 3 to 30 GHz, extremely high frequency (EHF) of 30 to 300 GHz, or any combination of two or more of these frequencies. For example, high frequency energy, commonly 13.56 MHz, is useful RF energy, and ultra-high frequency energy, commonly 2.54 GHz, is useful microwave energy, as two examples of commonly used frequencies.

The plasma exciting energy, in any embodiment, can either be continuous during a treatment step or pulsed multiple times during the treatment step. If pulsed, it can alternately pulse on for times ranging from one millisecond to one second, and then off for times ranging from one millisecond to one second, in a regular or varying sequence during plasma treatment. One complete duty cycle (one "on" period plus one "off" period) can be 1 to 2000 milliseconds (ms), optionally 1 to 1000 milliseconds (ms), optionally 2 to 500 ms, optionally 5 to 100 ms, optionally 10 to 100 ms long.

Optionally in any embodiment, the relation between the power on and power off portions of the duty cycle can be, for example, power on 1-90 percent of the time, optionally on 1-80 percent of the time, optionally on 1-70 percent of the time, optionally on 1-60 percent of the time, optionally on 1-50 percent of the time, optionally on 1-45 percent of the time, optionally on 1-40 percent of the time, optionally on 1-35 percent of the time, optionally on 1-30 percent of the time, optionally on 1-25 percent of the time, optionally on 1-20 percent of the time, optionally on 1-15 percent of the time, optionally on 1-10 percent of the time, optionally on 1-5 percent of the time, and power off for the remaining time of each duty cycle.

The plasma pulsing described in Mark J. Kushner, *Pulsed Plasma-Pulsed Injection Sources For Remote Plasma Activated Chemical Vapor Deposition,* J. APPL. PHYS. 73, 4098 (1993), can optionally be used.

The flow rate of process gas during plasma treatment according to any embodiment can be from 1 to 300 sccm (standard cubic centimeters per minute), optionally 1 to 200 sccm, optionally from 1 to 100 sccm, optionally 1-50 sccm, optionally 5-50 sccm, optionally 1-10 sccm.

Optionally in any embodiment, the plasma chamber is reduced to a base pressure from 0.001 milliTorr (mTorr, 0.00013 Pascal) to 100 Torr (13,000 Pascal) before feeding gases. Optionally the feed gas pressure in any embodiment can range from 0.001 to 10,000 mTorr (0.00013 to 1300 Pascal), optionally from 1 mTorr to 10 Torr (0.13 to 1300 Pascal), optionally from 0.001 to 5000 mTorr (0.00013 to 670 Pascal), optionally from 1 to 1000 milliTorr (0.13 to 130 Pascal).

The treatment volume in which the plasma is generated in any embodiment can be, for example, from 100 mL to 50 liters, preferably 8 liters to 20 liters.

The plasma treatment time in any embodiment can be, for example, from 1 to 300 seconds, optionally 3 to 300 sec., optionally 30 to 300 sec., optionally 150 to 250 sec., optionally 150 to 200 sec., optionally from 90 to 180 seconds.

The number of plasma treatment steps can vary, in any embodiment. For example one plasma treatment can be used; optionally two or more plasma treatments can be used, employing the same or different conditions.

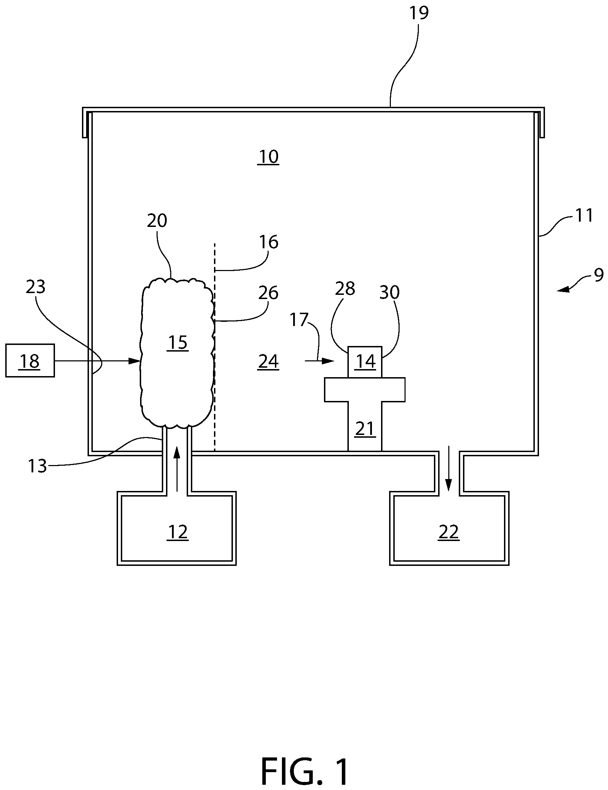

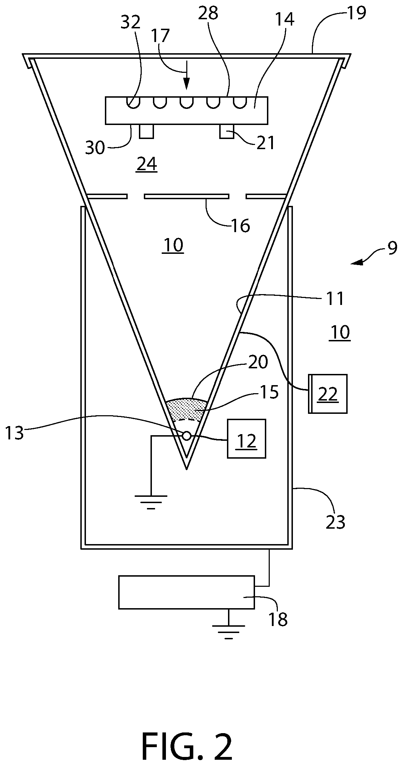

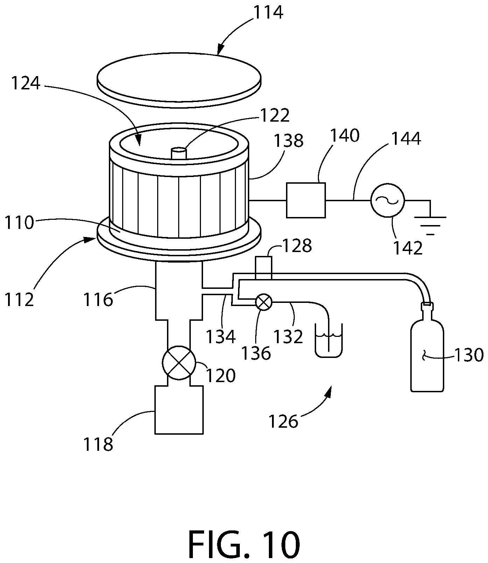

In any embodiment, the plasma treatment apparatus employed can be any suitable apparatus, for example that of FIG. 1, FIG. 7, FIG. 8, or FIG. 10 described in this specification, as several examples. Plasma treatment apparatus of the type that employs the lumen of the vessel to be treated as a vacuum chamber, shown for example in U.S. Patent 7,985,188, FIG. 2, can also be used in any embodiment.

The plasma treatment process of any embodiment optionally can be combined with treatment using an ionized gas. The ionized gas can be, as some examples, any of the gases identified as suitable for plasma treatment. The ionized gas can be delivered in any suitable manner. For example, it can be delivered from an ionizing blow-off gun or other ionized gas source. A convenient gas delivery pressure is from 1-120 psi (pounds per square inch) (6 to 830 kPa, kiloPascals) (gauge or, optionally, absolute pressure), optionally 50 psi (350 kPa). The water content of the ionized gas can be from 0 to 100%. The polar-treated surface with ionized gas can be carried out for any suitable treatment time, for example from 1-300 seconds, optionally for 10 seconds.

After the plasma treatment(s) of any embodiment, the treated surface, for example a vessel lumen surface, can be contacted with an aqueous protein. Some examples of suitable proteins are: mammal serum albumin, for example Bovine Serum Albumin (BSA); Fibrinogen (FBG); Transferrin (TFN), for example blood serotransferrin (or siderophilin, also known as transferrin); lactotransferrin (lactoferrin); milk transferrin; egg white ovotransferrin (conalbumin); and membrane-associated melanotransferrin; Protein A (PrA); Protein G (PrG); Protein A/G; Protein L; Insulin, for example hexameric insulin, monomeric insulin, porcine insulin, human insulin, recombinant insulin and pharmaceutical grades of insulin; Pharmaceutical protein; blood or blood component proteins; or any recombinant form, modification, full length precursor, signal peptide, propeptide, or mature variant of these proteins; or a combination of two or more of these.

Optionally, the treated surface has a protein recovery percentage greater than the protein recovery percentage of the unconditioned and unconverted surface for at least one of Bovine Serum Albumin (BSA); Fibrinogen (FBG); Transferrin (TFN), for example blood serotransferrin (or siderophilin, also known as transferrin); lactotransferrin (lactoferrin); milk transferrin; egg white ovotransferrin (conalbumin); and membrane-associated melanotransferrin; Protein A (PrA); Protein G (PrG); Protein A/G; Protein L; Insulin, for example hexameric insulin, monomeric insulin, porcine insulin, human insulin, recombinant insulin and pharmaceutical grades of insulin; pharmaceutical protein; blood or blood component proteins; or any recombinant form, modification, full length precursor, signal peptide, propeptide, or mature variant of these proteins.

MORE DETAILED EMBODIMENT

A vessel having a substrate according to the more detailed embodiment may be made, for example, from any of the plastic materials defined above. For applications in which clear and glass-like polymers are desired (e.g., for syringes and vials), a cyclic olefin polymer (COP), cyclic olefin copolymer (COC), polymethylmethacrylate, polyethylene terephthalate or polycarbonate may be preferred. Also contemplated are linear polyolefins such as polypropylene and aromatic polyolefins such as polystyrene. Such substrates may be manufactured, e.g., by injection molding or injection stretch blow molding (which is also classified as injection molding in this disclosure), to very tight and precise tolerances (generally much tighter than achievable with glass).

A vessel can be a sample tube, e.g. for collecting or storing biological fluids like blood or urine, a syringe (or a part thereof, for example a syringe barrel) for storing or delivering a biologically active compound or composition, e.g., a medicament or pharmaceutical composition, a vial for storing biological materials or biologically active compounds or compositions, a pipe, e.g., a catheter for transporting biological materials or biologically active compounds or compositions, or a cuvette for holding fluids, e.g., for holding biological materials or biologically active compounds or compositions. Other examples of vessels include well or non-well slides or plates, for example titer plates or microtiter plates (a.k.a. microplates). Other examples of vessels include measuring and delivery devices such as pipettes, pipette tips, Erlenmeyer flasks, beakers, and graduated cylinders. The specific vessels described herein with respect to an actual reduction to practice of an embodiment are polypropylene 96-well microplates and beakers. However, a skilled artisan would understand that the methods and equipment set-up described herein can be modified and adapted, consistent with the present invention, to accommodate and treat optional vessels.

The surface of the vessel may be made from the substrate material itself, e.g., any of the thermoplastic resins listed above. Optionally, the surface may be a pH protective coating or layer of PECVD deposited $SiO_xC_yH_z$ or $SiN_xC_yH_z$, in which x is from about 0.5 to about 2.4 as measured by X-ray photoelectron spectroscopy (XPS), y is from about 0.6 to about 3 as measured by XPS, and z is from about 2 to about 9 as measured by Rutherford backscattering spectrometry (RBS). Another example of the surface is a barrier coating or layer of PECVD deposited $SiO_x$, in which x is from about 1.5 to about 2.9 as measured by XPS, or an oxide or nitride of an organometallic precursor that is a compound of a metal element from Group III and/or Group IV of the Periodic Table, e.g. in Group III: Boron, Aluminum, Gallium, Indium, Thallium, Scandium, Yttrium, or Lanthanum (Aluminum and Boron being preferred), and in Group IV: Silicon, Germanium, Tin, Lead, Titanium, Zirconium, Hafnium, or Thorium (Silicon and Tin being preferred). Methods and equipment for depositing these coatings or layers are described in detail in WO2013/071138, published May 16, 2013.

Methods according to the more detailed embodiment employ the use of remote conversion plasma treatment. Unlike direct plasma processing, in the case of remote conversion plasma, neither ions nor electrons of plasma contact the article surface. Neutral species, typically having lower energy, are present in the plasma afterglow, which are sufficiently energetic to react with the article surface, without sputtering or other higher energy chemical reactions induced by ions and electrons. The result of remote conversion plasma is a gentle surface modification without the high energy effects of "direct" plasmas.

Methods according to the more detailed embodiment employ non-polymerizing gases, such as $O_2$, $N_2$, air, $O_3$, $N_2O$, $H_2$, $H_2O_2$, $NH_3$, Ar, He, Ne, other non-polymerizing gases, and combinations of any of two or more of the foregoing. These may also include non-polymerizing alcohols, non-polymerizing organic acids and non-polymerizing polar organic solvents. Experiments have been carried out in which the conditioning step (non-polymerizing compound step) used Ar, $N_2$, $Ar/O_2$ mix, or $N_2/O_2$ mix and a pre-treatment conditioning step with Ar. These and other non-polymerizing gases do not necessarily deposit a coating. Rather, they react with the surface to modify the surface, e.g., to form a treated surface, in which the treated surface has a biomolecule recovery percentage greater than the biomolecule recovery percentage of the unconditioned and unconverted surface. For example, the surface reactions may result in new chemical functional groups on the surface, including carbonyl, carboxyl, hydroxyl, nitrile, amide, amine. It is contemplated that these polar chemical groups increase the surface energy and hydrophilicity of otherwise hydrophobic polymers that an unconditioned and unconverted surface may typically comprise. While hydrophobic surfaces are generally good binding surfaces for biomolecules, hydrophilic surfaces, which attract water molecules, facilitate the blocking of biomolecules binding to that surface. While the invention is not limited according to this theory of operation, it is contemplated that this mechanism prevents biomolecule binding to surfaces.

Optionally, methods according to the more detailed embodiment may be used to reduce the propensity of a substrate surface to cause biomolecules to adhere thereto. Preferably, the methods will reduce biomolecule adhesion across a wide spectrum of biomolecules, including one or more of the following aqueous proteins: mammal serum albumin, for example Bovine Serum Albumin (BSA); Fibrinogen (FBG); Transferrin (TFN), for example blood serotransferrin (or siderophilin, also known as transferrin); lactotransferrin (lactoferrin); milk transferrin; egg white ovotransferrin (conalbumin); and membrane-associated melanotransferrin; Protein A (PrA); Protein G (PrG); Protein A/G; Protein L; Insulin, for example hexameric insulin, monomeric insulin, porcine insulin, human insulin, recombinant insulin and pharmaceutical grades of insulin; Pharmaceutical protein; blood or blood component proteins; or any recombinant form, modification, full length precursor, signal peptide, pro-peptide, or mature variant of these proteins; and a combination of two or more of these.

FIG. 1 is a schematic generic view of a remote conversion plasma treatment apparatus 9 having common features with each more particular embodiment of FIGS. 2, 6, 7, and 8 for carrying out remote conversion plasma treatment according to the invention. Plasma gas from a fluid source 12 capable of supporting the generation of plasma in the plasma zone 15 having a boundary 20 (plasma is defined here as a visible glow discharge) is introduced via a fluid inlet 13 to a plasma zone 15, and plasma energy from a plasma energy source 18 is provided to the plasma zone 15 to generate plasma having a boundary 20 in the plasma zone 15.

The plasma energy of the more detailed embodiment broadly can be any type of energy that will ignite plasma in the plasma zone 15. For example, it can be direct current (DC) or alternating current (electromagnetic energy) having a frequency from 3 Hz to 300 GHz. Electromagnetic energy in this range generally includes radio frequency (RF) energy and microwave energy, more particularly characterized as extremely low frequency (ELF) of 3 to 30 Hz, super low frequency (SLF) of 30 to 300 Hz, voice or ultra-low frequency (VF or ULF) of 300 Hz to 3kHz, very low frequency (VLF) of 3 to 30 kHz, low frequency (LF) of 30 to 300 kHz, medium frequency (MF) of 300 kHz to 3 MHz, high frequency (HF) of 3 to 30 MHz, very high frequency (VHF) of 30 to 300 MHz, ultra-high frequency (UHF) of 300 MHz to 3 GHz, super high frequency (SHF) of 3 to 30 GHz, extremely high frequency (EHF) of 30 to 300 GHz, or any combination of two or more of these frequencies. For example, high frequency energy, commonly 13.56 MHz, is useful RF energy, and ultra-high frequency energy, commonly 2.54 GHz, is useful microwave energy, as two examples of commonly used frequencies.

The nature of the optimal applicator 23 is determined by the frequency and power level of the energy, as is well known. If the plasma is excited by radio waves, for example, the applicator 23 can be an electrode, while if the plasma is excited by microwave energy, for example, the applicator 23 can be a waveguide.

An afterglow region 24 is located outside but near the plasma boundary 20, and contains treatment gas 17. The afterglow region 24 can be the entire treatment volume 10 outside the plasma boundary 20 and within the reaction chamber wall 1 and lid 19, or the afterglow region 24 can be a subset of the treatment volume 10, depending on the dimensions of and conditions maintained in the treatment volume. The treatment gas 17 in the afterglow region 24 is not ionized sufficiently to form plasma, but it is sufficiently energetic to be capable of modifying a surface that it contacts, more so than the same gas composition at the same temperature and pressure in the absence of the plasma.

It will be understood by a skilled person that some gas compositions are sufficiently chemically reactive that they will modify a substrate in the apparatus 9 when plasma is absent. The test for whether a region of, or adjacent to, remote conversion plasma treatment apparatus is within the afterglow, for given equipment, plasma, gas feed, and pressure or vacuum conditions producing a visible glow discharge outside the region, is whether a substrate located in the region under the given equipment, plasma, gas feed, and pressure is modified compared to a substrate exposed to the same equipment, gas feed and pressure or vacuum conditions, when no plasma is present in the plasma zone as the result of the absence of or insufficiency of the plasma energy 18.

Remote conversion plasma treatment is carried out by providing plasma in the plasma zone 15, which generates an afterglow in the afterglow region or remote conversion plasma (two terms for the same region) 24, which contacts and modifies a substrate placed at least partially in the afterglow region 24.

As one option in the remote conversion plasma treatment apparatus, the plasma gas enters the plasma zone, is excited to form plasma, then continues downstream to the afterglow region 24 where it has less energy, is then defined as treatment gas 17, and contacts the substrate. In other words, at least a portion of the gas flows through the plasma zone 15, is energized to form plasma, and continues to the afterglow region 24, becoming more energetic in the plasma zone 15 and less energetic by the time it enters the afterglow region 24 (but still energized compared to the gas before entering the plasma zone 15). Where this option is adopted, the plasma and the afterglow region 24 are in gas communication and at least some of the same gas is fed through both zones. Optionally, as where plasma is not generated in the entire cross-section of flowing gas, some of the gas may bypass the plasma by staying outside the boundary 20 of the plasma zone 15 and still flow through the afterglow region 24, while other gas flows through both the plasma zone 15 and the afterglow region 24.

As another option in the remote conversion plasma treatment, the plasma gas can be different molecules from the treatment gas 17 (though the plasma gas and treatment gas may either have identical compositions or different compositions), and the plasma gas remains in or is fed through only the plasma zone 15 and not the afterglow region 24, while the treatment gas is energized by the plasma gas but is separate from the plasma gas and while in the afterglow region 24 is not energized sufficiently to form plasma.

The nature of the applicator 23 can vary depending on the application conditions, for example the power level and frequency of the plasma energy 18. For example, the applicator can be configured as an electrode, antenna, or waveguide.

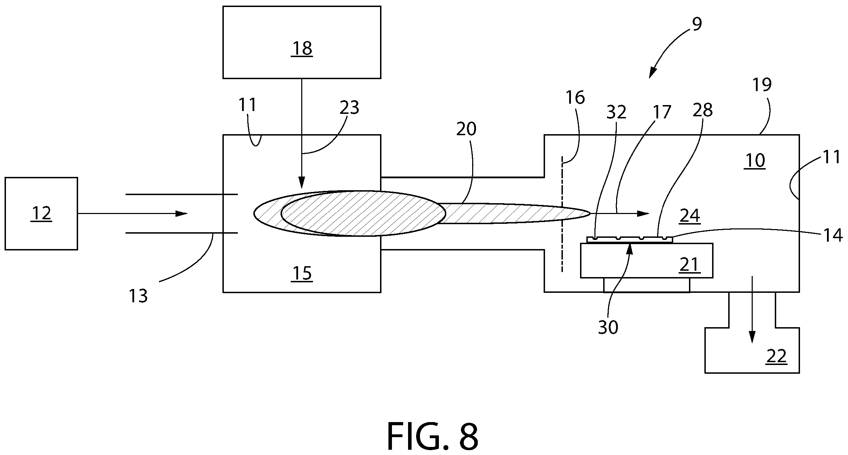

Optionally, a shield 16 may be placed between the plasma and at least a portion of the substrate 14 in the treatment area to prevent the plasma from contacting or coming undesirably close to the substrate 14 or unevenly affecting the substrate 14. For one example, the optional shield 16 in FIG. 1 can be perforated to allow gas flow through it, particularly flow of the neutral species forming the afterglow, but the shield 16 is configured or equipped, suitably for the choice of plasma-forming energy, to prevent the plasma from penetrating the shield. For example, the perforations may be sized or the shield can be electrically biased such that the plasma-forming energy or the plasma cannot pass through it. This arrangement has the advantage that, if the plasma zone has a substantial area intersecting with the shield, the substantial area optionally is flattened so the plasma boundary 20 has a "flat spot" 26, illustrated in FIG. 1, which can be placed parallel to the surface of the substrate to be treated so they are equidistant over a substantial area, instead of the plasma terminating in a tapered tail that extends much closer to one portion of the substrate 14 than to other parts of the substrate 14 not aligned with the tail, illustrated in FIG. 8.

Another shield option is that the shield can be made such that it passes neither gas nor plasma, serving as an obstruction of the direct path between some or all of the plasma and some or all of the treatment area. The obstruction can fill less than all of the gas cross-section flowing from the plasma zone 15 to the afterglow region 24, so non-ionized gas can flow around the shield and reach the afterglow region 24 by a circuitous path, while plasma cannot either circumvent or pass through it.

Yet another shield option is that the substrate 14 to be treated can be positioned in the apparatus during treatment such that one portion of a substrate 14 that can withstand contact with plasma is exposed to the plasma, shielding from the plasma another portion of the substrate 14 or another substrate receiving remote conversion plasma treatment.

Still another shield option is that the gas flow path through the plasma and treatment area can be sharply bent, for example turning a 90 degree corner between the plasma and treatment area, so the wall of the apparatus itself shields the treatment area from line-of-sight relation to the plasma under certain treatment conditions.

The substrate orientation in the treatment volume can vary, and the substrate, applicator, gas and vacuum sources can optionally be arranged to provide either substantially even or uneven exposure to remote conversion plasma across a substrate.

Another option is that the substrate itself can serve as the reactor wall or a portion of the reactor wall, so treatment gas 17 introduced into reactor treats the portion of the substrate serving as the reactor wall.

Another option is the introduction of a second non-polymerizing gas, functioning as diluent gas, into the reactor, in addition to the non-polymerizing compound or water vapor which is the active agent of the treatment gas 17. Diluent gases are defined as gases introduced at the fluid inlet 13 that do not materially interact with the substrate 14 to the extent they find their way into the treatment gas 17, given the treatment apparatus and conditions applied. Diluent gases can either participate or not participate in formation of the plasma. The diluent gas can be introduced through the inlet 13 or elsewhere in the reactor. Diluent gases can be added at a rate from 1% to 10,000% by volume, optionally 10% to 1000% by volume, optionally 100% to 1000% by volume, of the rate of addition of the non-polymerizing compound or water vapor.

As another option, some or all of the non-polymerizing compound or water vapor can be added to the treatment volume 10 in such a manner as to bypass the plasma zone 15 en route to the treatment gas 17.

FIG. 2 shows another version of the apparatus of FIG. 1. The apparatus again can be used for carrying out the remote conversion plasma treatment according to the more detailed embodiment. The chamber of this apparatus comprises a treatment volume 10 defined and enclosed by a reaction chamber wall 11, which optionally is not electrically conductive. The treatment volume 10 is supplied with a fluid source 12 (in this instance, a tubular fluid inlet 13 projecting axially into the treatment volume 10, however other fluid sources are contemplated, e.g., "shower head" type fluid sources). Optionally, the treatment volume 10 can be defined by a treatment chamber wall 11 or by the lumen within a vessel or other article to be treated. Feed gases are fed into the treatment volume 10. The plasma reaction chamber comprises as an optional feature a vacuum source 22 for at least partially evacuating the treatment volume 10 compared to ambient pressure, for use when plasma treating at reduced pressure, although plasma treating under suitable conditions at ambient atmospheric pressure or at a pressure higher than ambient atmospheric pressure is also contemplated.

The plasma reaction chamber also comprises an optional outer applicator 23, here in the form of an electrode surrounding at least a portion of the plasma reaction chamber. A radio frequency (RF) plasma energy source 18 is coupled to the reaction chamber by an applicator 23 and provides power that excites the gases to form plasma. The plasma forms a visible glow discharge 20 that optionally is limited to a close proximity to the fluid source 12.

Microplates 14 optionally can be oriented such that the surfaces of the microplates 14 on which treatment is desired (the surface that is configured and intended to contact/hold a biomolecule-containing solution) face the fluid source 12. However, the surfaces to be treated can also or instead face away from the fluid source 12, as shown in FIG. 2. In addition, in the illustrated arrangement the microplate 14 is shielded with a shield 16 to block the microplate 14 from being in the direct "line of sight" of (i.e. having an unobstructed path to) the fluid source 12. As an example, the respective surfaces of the microplates 14 can be positioned a horizontal distance of approximately 2.75 inches (7 cm) from the fluid source, although operation is contemplated with placement of the microplate 14 surfaces at a horizontal distance of from ½ to 10 inches (1 to 25 cm), optionally 2.5 to 5.5 inches (6 to 14 cm) from the fluid source. In this manner, the process relies on remote conversion plasma (as opposed to direct plasma) to treat the microplates' 14 surfaces. In this example, the system has a capacity of 20 parts (microplates) per batch at a total process time of eight minutes per batch.

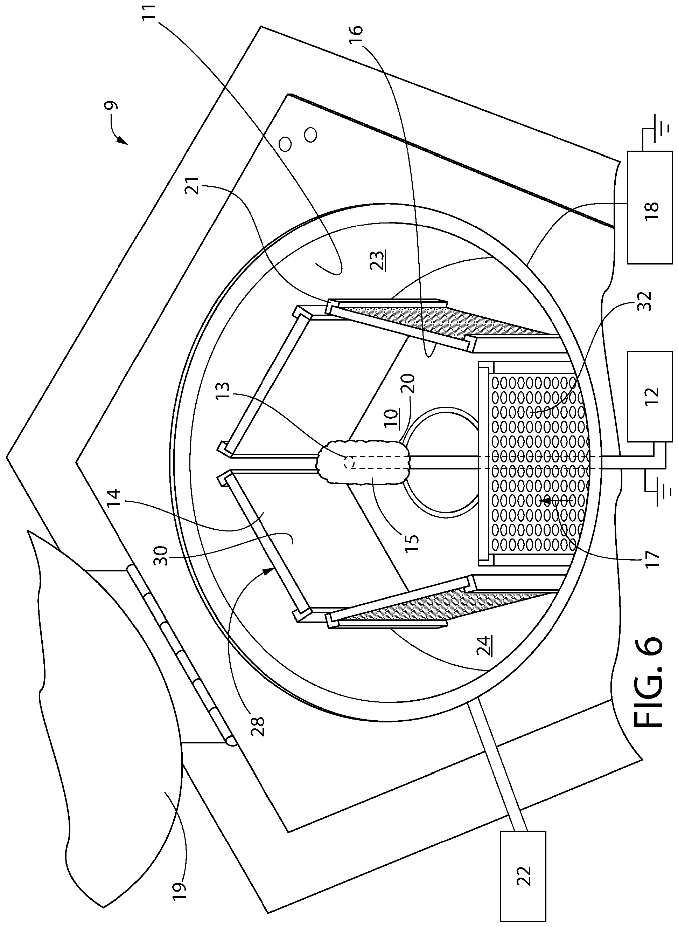

FIG. 6 shows another version of the apparatus of FIG. 1. The process used to treat the microplates in FIG. 6 uses a radio-frequency (RF) plasma system. The system has a gas delivery input, a vacuum pump and RF power supply with matching network. The microplates are shown oriented with the front surfaces containing the wells 32 facing away from and shielded from the plasma along the perimeter of the chamber.

These details are illustrated in FIG. 6, where there is shown another exemplary setup having all the elements of the apparatus of FIG. 2 for use in a plasma reaction chamber for carrying out remote conversion plasma treatment according to the more detailed embodiment. In this case, the chamber comprised a treatment volume 10 defined and enclosed by a reaction chamber wall 11 having a fluid source 12 (in this instance, a tubular fluid inlet 13 projecting axially into the treatment volume 10, however other fluid sources are contemplated, e.g., "shower head" type fluid sources). The reaction chamber wall 11 was provided with a removable lid 13 that is openable to allow substrates to be inserted or removed and sealable to contain the process and, optionally, evacuate the treatment volume. The fluid source 12 was made of metallic material, electrically grounded, and also functioned as an applicator, in the form of an inner electrode. As is well known, the plasma optionally can be generated without an inner electrode.

Feed gases were fed into the treatment volume 10. The plasma reaction chamber comprised an optional feature of a vacuum source 22 for at least partially evacuating the treatment volume 10. The plasma reaction chamber wall 11 also functioned as an applicator 23 in the form of an outer applicator or electrode surrounding at least a portion of the plasma reaction chamber. A plasma energy source 18, in this instance a radio frequency (RF) source, was coupled to applicators 23 defined by the reaction chamber wall 24 and the fluid source 12 to provide power that excited the gases to form plasma. The plasma zone 15 formed a visible glow discharge that was limited by the plasma boundary 20 in close proximity to the fluid source 12. The afterglow region also known as a remote conversion plasma region 24 is the region radially or axially outside the boundary 20 of the visible glow discharge and extending beyond the substrates treated.

Microplates 14 having front surfaces 28 and back surfaces 30 were oriented such that the wells 32 on the front surfaces of the microplates 14 on which treatment was desired (the front surface that is configured and intended to contact/hold a biomolecule-containing solution) faced away from the fluid source 12 and the back surfaces 30 faced toward the fluid source 12. The front surfaces 28 of the microplates 14 were shielded by their own back surfaces 30 to block the microplate front surfaces 28 from being in the direct "line of sight" of the fluid source 12. In this manner, the process relied on remote conversion plasma (as opposed to direct plasma) to treat the surfaces of the wells 32.

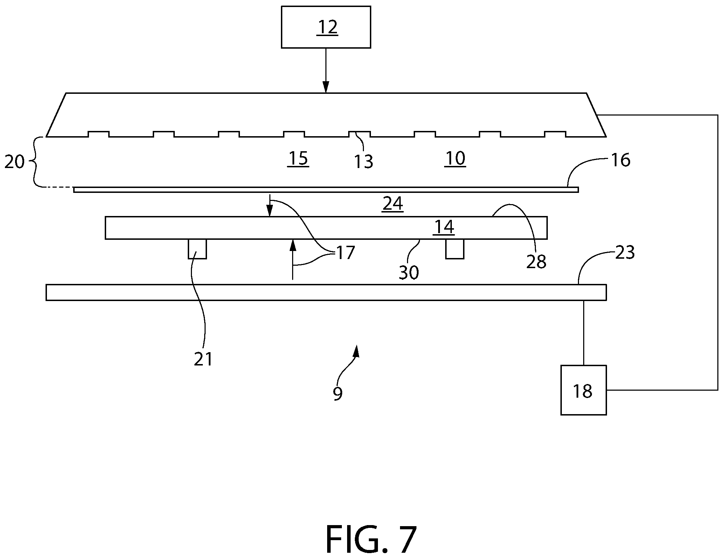

FIG. 7 shows another version of the apparatus of FIG. 1, having corresponding features. The version of FIG. 7 provides a "shower head" fluid inlet 13 and a plate electrode as the applicator 23 that provide more uniform generation and application of treatment gas 17 over a wider area of the substrate 14.

FIG. 8 shows another version of the apparatus of FIG. 1, having corresponding features. The version of FIG. 8 provides microwave plasma energy 18 delivered through an applicator 23 configured as a waveguide. In this version the plasma zone 15 and substrate support 21 are provided in separate vessels connected by a conduit.

Optionally, the treated surface has a biomolecule recovery percentage greater than the biomolecule recovery percentage of the unconditioned and unconverted surface for at least one of Bovine Serum Albumin (BSA); Fibrinogen (FBG); Transferrin (TFN), for example blood serotransferrin (or siderophilin, also known as transferrin); lactotransferrin (lactoferrin); milk transferrin; egg white ovotransferrin (conalbumin); and membrane-associated melanotransferrin; Protein A (PrA); Protein G (PrG); Protein A/G; Protein L; Insulin, for example hexameric insulin, monomeric insulin, porcine insulin, human insulin, recombinant insulin and pharmaceutical grades of insulin; pharmaceutical protein; blood or blood component proteins; or any recombinant form, modification, full length precursor, signal peptide, propeptide, mature variant of these proteins and a combination of two or more of these.

In one embodiment, a plasma treatment process comprises, consists essentially of, or consists of the following two steps using remote conversion plasma: (1) an oxygen plasma step (or more generically, a non-polymerizing compound plasma step) followed by (2) a water vapor plasma step. It should be understood that additional steps prior to, between or after the aforementioned steps may be added and remain within the scope of the more detailed embodiment. Further, it should also be understood that the oxygen plasma step may utilize optional gases in addition to oxygen, including nitrogen or any non-polymerizing gases listed in this specification.

Optional process parameter ranges for the conditioning step (non-polymerizing compound plasma step) and conversion step (water vapor plasma step) of the more detailed embodiment are set forth in Table 1.

**Table 1** - **Process parameter ranges for plasma treatment**

| Non-Polymerizing Compound Plasma Step | | Water Vapor Plasma Step | |
|---|---|---|---|
| Power (W) | 50-600 | Power (W) | 50-600 |
| Gas Flow rate (sccm) | 5-50 | $H_2O$ Flow rate (sccm) | 1-10 |
| Time (minutes) | 0.5-5 | Time (minutes) | 0.05-5 |
| Pressure (mTorr) | 0-1,000 | Pressure (mTorr) | 0-5,000 |

Optionally, no pretreatment step is required prior to the non-polymerizing gas plasma step.

Optionally, the remote conversion plasma used to treat a substrate surface may be RF generated plasma. Optionally, plasma enhanced chemical vapor deposition (PECVD) or other plasma processes may be used consistent with the more detailed embodiment.

Optionally, the treatment volume in a plasma reaction chamber may be from 100 mL to 50 liters, preferably 8 liters to 20 liters for certain applications. Optionally, the treatment volume may be generally cylindrical, although other shapes and configurations are also contemplated.

In an aspect of the substrate in any embodiment the converted and optionally conditioned surface has a biomolecule recovery percentage of at least 40%, optionally at least 45%, optionally at least 50%, optionally at least 55%, optionally at least 60%, optionally at least 65%, optionally at least 70%, optionally at least 75%, optionally at least 80%, optionally at least 85%, optionally at least 90% optionally at least 95%.

In an aspect of the substrate in any embodiment the converted and optionally conditioned surface is a vessel lumen surface.

In an aspect of the substrate in any embodiment the biomolecule recovery percentage is determined for at least one of: mammal serum albumin; Bovine Serum Albumin (BSA); Fibrinogen (FBG); Transferrin (TFN); egg white ovotransferrin (conalbumin); membrane-associated melanotransferrin; Protein A (PrA); Protein G (PrG); Protein A/G; Protein L; Insulin; Pharmaceutical protein; blood or blood component proteins; and any recombinant form, modification, full length precursor, signal peptide, propeptide, or mature variant of these proteins.

In an aspect of the substrate in any embodiment the converted and optionally conditioned surface comprises thermoplastic material, for example a thermoplastic resin, for example an injection-molded thermoplastic resin.

In an aspect of the substrate in any embodiment the converted and optionally conditioned surface comprises a hydrocarbon, for example an olefin polymer, polypropylene (PP), polyethylene (PE), cyclic olefin copolymer (COC), cyclic olefin polymer (COP), polymethylpentene, polystyrene, hydrogenated polystyrene, polycyclohexylethylene (PCHE), or combinations of two or more of these. The converted and optionally conditioned surface optionally comprises a heteroatom-substituted hydrocarbon polymer, for example a polyester, polyethylene terephthalate, polyethylene naphthalate, polybutylene terephthalate (PBT), polyvinylidene chloride (PVdC), polyvinyl chloride (PVC), polycarbonate, polylactic acid, epoxy resin, nylon, polyurethane polyacrylonitrile, polyacrylonitrile (PAN), an ionomeric resin, Surlyn® ionomeric resin, or any combination, composite or blend of any two or more of the above materials.

In an aspect of the substrate in any embodiment the converted and optionally conditioned surface is a coating or layer of PECVD deposited $SiO_xC_yH_z$ or $SiN_xC_yH_z$, in which x is from about 0.5 to about 2.4 as measured by X-ray photoelectron spectroscopy (XPS), y is from about 0.6 to about 3 as measured by XPS, and z is from about 2 to about 9 as measured by Rutherford backscattering spectrometry (RBS).

In an aspect of the substrate in any embodiment, the converted and optionally conditioned surface is a barrier coating or layer of $SiO_x$, in which x is from about 1.5 to about 2.9 as measured by XPS, or an oxide or nitride of an organometallic precursor that is a compound of a metal element from Group III and/or Group IV of the Periodic Table, e.g. in Group III: Boron, Aluminum, Gallium, Indium, Thallium, Scandium, Yttrium, or Lanthanum (Aluminum and Boron being preferred), and in Group IV: Silicon, Germanium, Tin, Lead, Titanium, Zirconium, Hafnium, or Thorium (Silicon and Tin being preferred).

In an aspect of the substrate in any embodiment the converted and optionally conditioned surface is a fluid surface of an article of labware. For example, the converted and optionally conditioned surface can be a fluid surface of a microplate, a centrifuge tube, a pipette tip, a well plate, a microwell plate, an ELISA plate, a microtiter plate, a 96-well plate, a 384-well plate, a vial, a bottle, a jar, a syringe, a cartridge, a blister package, an ampoule, an evacuated blood collection tube, a specimen tube, a centrifuge tube, or a chromatography vial.

In an aspect of any embodiment the converted and optionally conditioned surface is a vessel lumen surface.

In an aspect of any embodiment the converted and optionally conditioned surface is in contact with an aqueous protein. In an aspect of any embodiment the aqueous protein comprises: mammal serum albumin, for example Bovine Serum Albumin (BSA); Fibrinogen (FBG); Transferrin (TFN), for example blood serotransferrin (or siderophilin, also known as transferrin); lactotransferrin (lactoferrin); milk transferrin; egg white ovotransferrin (conalbumin); and membrane-associated melanotransferrin; Protein A (PrA); Protein G (PrG); Protein A/G; Protein L; Insulin, for example hexameric insulin, monomeric insulin, porcine insulin, human insulin, recombinant insulin and pharmaceutical grades of insulin; Pharmaceutical protein; blood or blood component proteins; or any recombinant form, modification, full length precursor, signal peptide, propeptide, or mature variant of these proteins; or a combination of two or more of these.

In an aspect of any embodiment the converted and optionally conditioned surface has a protein recovery percentage greater than the protein recovery percentage of the unconditioned and unconverted surface for at least one of Bovine Serum Albumin (BSA); Fibrinogen (FBG); Transferrin (TFN), for example blood serotransferrin (or siderophilin, also known as transferrin); lactotransferrin (lactoferrin); milk transferrin; egg white ovotransferrin (conalbumin); and membrane-associated melanotransferrin; Protein A (PrA); Protein G (PrG); Protein A/G; Protein L; Insulin, for example hexameric insulin, monomeric insulin, porcine insulin, human insulin, recombinant insulin and pharmaceutical grades of insulin; Pharmaceutical protein; blood or blood component proteins; or any recombinant form, modification, full length precursor, signal peptide, propeptide, or mature variant of these proteins.

In an aspect of any embodiment the converted and optionally conditioned surface has a protein recovery percentage greater than the protein recovery percentage of the unconditioned and unconverted surface for Bovine Serum Albumin having an atomic mass of 66,000 Daltons (BSA) on NUNC® 96-well round bottom plates, following the protocol in the present specification.

In an aspect of any embodiment the converted and optionally conditioned surface has a protein recovery percentage at 24 hours on NUNC® 96-well round bottom plates greater than 70%, optionally greater than 80%, optionally greater than 90%, optionally up to 100% for BSA, following the protocol in the present specification.

In an aspect of any embodiment the converted and optionally conditioned surface has a protein recovery percentage at 24 hours greater than the protein recovery percentage of the unconditioned and unconverted surface for Fibrinogen having an atomic mass of 340,000 Daltons (FBG) on NUNC® 96-well round bottom plates, following the protocol in the present specification.

In an aspect of any embodiment the converted surface has a protein recovery percentage at 24 hours on NUNC® 96-well round bottom plates greater than 20%, optionally greater than 40%, optionally greater than 60%, optionally greater than 80%, optionally up to 84% for FBG, following the protocol in the present specification.

In an aspect of any embodiment the converted surface has a protein recovery percentage at 24 hours on NUNC® 96-well round bottom plates greater than the protein recovery percentage of the unconditioned and unconverted surface for Transferrin having an atomic mass of 80,000 Daltons (TFN), following the protocol in the present specification.

In an aspect of in any embodiment the converted surface has a protein recovery percentage at 24 hours on NUNC® 96-well round bottom plates greater than 60%, optionally greater than 65%, optionally greater than 69%, optionally up to 70% for TFN, following the protocol in the present specification.

In an aspect of any embodiment the converted surface has a protein recovery percentage at 24 hours on NUNC® 96-well round bottom plates greater than the protein recovery percentage of the unconditioned and unconverted surface for Protein A having an atomic mass of 45,000 Daltons (PrA), following the protocol in the present specification.

In an aspect of any embodiment the converted surface has a protein recovery percentage at 24 hours on NUNC® 96-well round bottom plates greater than 9%, optionally greater than 20%, optionally greater than 40%, optionally greater than 60%, optionally up to 67% for PrA, following the protocol in the present specification.

In an aspect of any embodiment the converted surface has a protein recovery percentage at 24 hours on NUNC® 96-well round bottom plates greater than the protein recovery percentage of the unconditioned and unconverted surface for Protein G having an atomic mass of 20,000 Daltons (PrG), following the protocol in the present specification.

In an aspect of any embodiment the converted surface has a protein recovery percentage at 24 hours on NUNC® 96-well round bottom plates greater than 12%, optionally greater than 20%, optionally greater than 40%, optionally greater than 60%, optionally greater than 80%, optionally up to 90% for PrG, following the protocol in the present specification.

In an aspect of any embodiment the converted surface has a protein recovery percentage at 24 hours greater than the protein recovery percentage of the unconditioned and unconverted surface for Bovine Serum Albumin having an atomic mass of 66,000 Daltons (BSA) on Eppendorf LoBind® low-protein-binding 96-well round bottom plates, following the protocol in the present specification. Eppendorf LoBind® is a trademark of Eppendorf AG, Hamburg, Germany.

In an aspect of any embodiment the converted surface has a protein recovery percentage at 24 hours on Eppendorf LoBind® 96-well round bottom plates greater than 95% for BSA, following the protocol in the present specification.

In an aspect of any embodiment the converted surface has a protein recovery percentage at 24 hours greater than the protein recovery percentage of the unconditioned and unconverted surface for Fibrinogen having an atomic mass of 340,000 Daltons (FBG) on Eppendorf LoBind® 96-well round bottom plates, following the protocol in the present specification.

In an aspect of any embodiment the converted surface has a protein recovery percentage at 24 hours on Eppendorf LoBind® 96-well round bottom plates greater than 72% for FBG, following the protocol in the present specification.

In an aspect of any embodiment the converted surface has a protein recovery percentage at 24 hours on Eppendorf LoBind® 96-well round bottom plates greater than the protein recovery percentage of the unconditioned and unconverted surface for Transferrin having an atomic mass of 80,000 Daltons (TFN), following the protocol in the present specification.

In an aspect of any embodiment the converted surface has a protein recovery percentage at 24 hours on Eppendorf LoBind® 96-well round bottom plates greater than 69% for TFN, following the protocol in the present specification.

In an aspect of any embodiment the converted surface has a protein recovery percentage at 24 hours on Eppendorf LoBind® 96-well round bottom plates greater than the protein recovery percentage of the unconditioned and unconverted surface for Protein A having an atomic mass of 45,000 Daltons (PrA), following the protocol in the present specification.

In an aspect of any embodiment the converted surface has a protein recovery percentage at 24 hours on Eppendorf LoBind® 96-well round bottom plates greater than the protein recovery percentage of the unconditioned and unconverted surface for Protein G having an atomic mass of 20,000 Daltons (PrG), following the protocol in the present specification.

In an aspect of any embodiment the converted surface has a protein recovery percentage at 24 hours on Eppendorf LoBind® 96-well round bottom plates greater than 96% for PrG, following the protocol in the present specification.

In an aspect of any embodiment the converted surface has a protein recovery percentage at 24 hours greater than the protein recovery percentage of the unconditioned and unconverted surface for Bovine Serum Albumin having an atomic mass of 66,000 Daltons (BSA) on GREINER® 96-well round bottom plates, following the protocol in the present specification.

In an aspect of any embodiment the converted surface has a protein recovery percentage at 24 hours on GREINER® 96-well round bottom plates greater than 60%, optionally up to 86%, for BSA, following the protocol in the present specification.

In an aspect of any embodiment the converted surface has a protein recovery percentage at 24 hours greater than the protein recovery percentage of the unconditioned and unconverted surface for Fibrinogen having an atomic mass of 340,000 Daltons (FBG) on GREINER® 96-well round bottom plates, following the protocol in the present specification.

In an aspect of any embodiment the converted surface has a protein recovery percentage at 24 hours on GREINER® 96-well round bottom plates greater than 50%, optionally up to 65%, for FBG, following the protocol in the present specification.

In an aspect of any embodiment the converted surface has a protein recovery percentage at 24 hours on GREINER® 96-well round bottom plates greater than the protein recovery percentage of the unconditioned and unconverted surface for Transferrin having an atomic mass of 80,000 Daltons (TFN), following the protocol in the present specification.

In an aspect of any embodiment the converted surface has a protein recovery percentage at 24 hours on GREINER® 96-well round bottom plates greater than 50%, optionally up to 60%, for TFN, following the protocol in the present specification.

In an aspect of any embodiment the converted surface has a protein recovery percentage at 24 hours on GREINER® 96-well round bottom plates greater than the protein recovery percentage of the unconditioned and unconverted surface for Protein A having an atomic mass of 45,000 Daltons (PrA), following the protocol in the present specification.

In an aspect of any embodiment the converted surface has a protein recovery percentage at 24 hours on GREINER® 96-well round bottom plates greater than 25%, optionally up to 56%, for PrA, following the protocol in the present specification.

In an aspect of any embodiment the converted surface has a protein recovery percentage at 24 hours on GREINER® 96-well round bottom plates greater than the protein recovery percentage of the unconditioned and unconverted surface for Protein G having an atomic mass of 20,000 Daltons (PrG), following the protocol in the present specification.

In an aspect of any embodiment the converted surface has a protein recovery percentage at 24 hours on GREINER® 96-well round bottom plates greater than 60%, optionally up to 75%, for PrG, following the protocol in the present specification.

In an aspect of any embodiment the surface consists essentially of polypropylene, optionally polypropylene homopolymer.

In an aspect of any embodiment the converted polypropylene surface has a protein recovery percentage greater than the protein recovery percentage of the unconditioned and unconverted polypropylene surface for Bovine Serum Albumin having an atomic mass of 66,000 Daltons (BSA), following the protocol in the present specification.

In an aspect of any embodiment the converted polypropylene surface has a protein recovery percentage greater than the protein recovery percentage of the unconditioned and unconverted polypropylene surface for Fibrinogen having an atomic mass of 340,000 Daltons (FBG), following the protocol in the present specification.

In an aspect of any embodiment the converted polypropylene surface has a protein recovery percentage greater than the protein recovery percentage of the unconditioned and unconverted polypropylene surface for Transferrin having an atomic mass of 80,000 Daltons (TFN), following the protocol in the present specification.

In an aspect of any embodiment the converted polypropylene surface has a protein recovery percentage greater than the protein recovery percentage of the unconditioned and unconverted polypropylene surface for Protein A having an atomic mass of 45,000 Daltons (PrA), following the protocol in the present specification.

In an aspect of any embodiment the converted polypropylene surface has a protein recovery percentage greater than the protein recovery percentage of the unconditioned and unconverted polypropylene surface for Protein G having an atomic mass of 20,000 Daltons (PrG), following the protocol in the present specification.

## Working Examples

Various aspects will be illustrated in more detail with reference to the following Examples, but it should be understood that the more detailed embodiment is not deemed to be limited thereto.

## Testing of all embodiments

The following protocol was used to test the plates in all embodiments, except as otherwise indicated in the examples:

Purpose: The purpose of this experiment was to determine the amount of protein binding over time to a surface coated microtiter plate (a microtiter plate is also referred to in this disclosure as a "microplate;" both terms have identical meaning in this disclosure).

Materials: BIOTEK® Synergy H1 Microplate Reader and BIOTEK Gen5® Software, MILLIPORE® MILLI-Q® Water System (sold by Merck KGAA, Darmstadt, Germany), MILLIPORE® Direct Detect Spectrometer, ALEXA FLUOR® 488 Labeled Proteins (Bovine Serum Albumin (BSA), Fibrinogen (FBG), Transferrin (TFN), Protein A (PrA) and Protein G (PrG), sold by Molecular Probes, Inc., Eugene, Oregon USA), 10X Phosphate Buffered Saline (PBS), NUNC® Black 96-well Optical Bottom Plates, 1 L Plastic Bottle, 25-100 mL Glass Beakers, Aluminum Foil, 1-10 mL Pipette, 100-1000 $\mu$L Pipette, 0.1-5 $\mu$L Pipette, 50-300 $\mu$L Multichannel Pipette.

The selected proteins, one or more of those listed above, were tested on a single surface coated microplate. Each protein was received as a fluorescently labeled powder, labeled with ALEXA FLUOR® 488:

- 5 mg of BSA: 66,000 Da
- 5 mg of FBG: 340,000 Da
- 5 mg of TFN: 80,000 Da
- 1 mg of PrA: 45,000 Da
- 1 mg of PrG: 20,000 Da

Once received, each vial of protein was wrapped in aluminum foil for extra protection from light and labeled accordingly, then placed into the freezer for storage.

A solution of 1 X PBS (phosphate buffer solution) was made from a stock solution of 10X PBS: 100mL of 10X PBS was added to a plastic 1L bottle, followed by 900mL of distilled water from the MILLIPORE® Q-pod, forming 1X PBS. Using a 100-1000 $\mu$L pipette, 1000 $\mu$L of 1X PBS was pipetted into each vial of protein separately, to create protein solutions. Each vial was then inverted and vortexed to thoroughly mix the solution.

Each protein was then tested on the MILLIPORE® Direct to get an accurate protein concentration. Using a 0.1-5 $\mu$L pipette, a 2 $\mu$L sample of PBS was placed on the first spot of the Direct Detect reading card and marked as a blank in the software. A 2 $\mu$L sample of the first protein was then placed onto the remaining 3 spots and marked as samples. After the card was read, an average of the 3 protein concentrations was recorded in mg/mL. This was repeated for the remaining four proteins. The protein solutions were then placed into the refrigerator for storage.

A standard curve was prepared with 1X PBS for each protein. The standard curve started at 25 nM and a serial 2x dilution was performed to obtain the other tested concentrations, for example one or more of 12.5 nM, 6.25 nM, 3.125 nM and 1.5625 nM. Further dilutions to 0.5 nM were also prepared in some instances. The 12.5 nM solution prepared from the standard curve was used for testing.

Once the dilutions for all tested proteins were done, the standard curve for each protein was prepared and tested as follows. 25 100-mL glass beakers were set into rows of 5. Each beaker was wrapped in aluminum foil and labeled with the name of the protein the curve corresponded to and the concentration of the solution in the beaker. Row 1 was the standard curve for BSA; row 2, FBG; row 3, TFN; row 4, PrA; row 5, PrG. Therefore the first row was labeled as follows: BSA 25 nM, BSA 12.5 nM, BSA 6.25 nM, BSA 3.125 nM, BSA 1.56 nM.

After a standard curve was made, it was tested using the microplate reader, then the next standard curve was made and tested, and so on.

The BIOTEK® Synergy H1 microplate reader and BIOTEK Gen5® software were used for analysis.

After the first standard curve was prepared, it was ready to be tested on the Synergy H1. Using a 50-300 $\mu$L multichannel pipette, 200 $\mu$L of 1X PBS was pipetted into wells A1-A4 of a black optical bottom microplate. Then, 200 $\mu$L of the 25 nM solution was pipetted into wells B1-B4, 200 $\mu$L of 12.5 nM solution was pipetted into wells C1-C4, 200 $\mu$L of 12.5 nM solution was pipetted into wells D1-D4, 200 $\mu$L of 12.5 nM solution was pipetted into wells E1-E4, 200 $\mu$L of 12.5 nM solution was pipetted into wells F1-F4, and 200 $\mu$L of 12.5 nM solution was pipetted into wells G1-G4. A similar procedure was used to fill the wells with other dilutions of the protein solution.

Once the microplate was filled with solution, it was wrapped in aluminum foil and the sections and time points were labeled.

After 1.5 hours, using a 50-300 $\mu$L multichannel pipette and poking through the aluminum foil, 200 $\mu$L of BSA solution was pipetted from the wells in the 1.5 hr column (column 1) and placed into a black optical bottom microplate. The black microplate was placed into the microplate tray. The other four proteins were then read the same way by opening their corresponding experiments. The same thing was done after 2.5 hours, 4.5 hours and 24 hours. After the 24 hr read, "Plate --t Export" was then selected from the menu bar. An excel spreadsheet will appear and can then be saved in the desired location with the desired name.

Using the data produced by the BIOTEK Gen5® software, the 12.5 nM solution concentrations from both the standard curve and SPL1 were averaged. The concentrations in the 4 wells at 1.5 hr were averaged. This was then done for 2.5 hr, 4.5 hr and 24 hr also. The average concentration at each time point was then divided by the average concentration of The 12.5 nM solution from the beginning and multiplied by 100 to get a percent recovery at each time point:

$$\% \text{ Recovery @ 1.5hr} = [\text{AVG. BSA 1.5 hr}] / [\text{AVG 12.5 nM solution}] * 100$$

## EXAMPLES

### Example 1 of the more detailed embodiment

Polypropylene 96-well microplates were plasma treated according to the more detailed embodiment. The process used to treat the microplates used a radio-frequency (RF) plasma system. The system had a gas delivery input, a vacuum pump and RF power supply with matching network. The microplates were oriented facing away from and shielded from the plasma along the perimeter of the chamber. These details are illustrated in FIG. 2. The shielding resulted in remote plasma treatment in which the ratio between the radiant density at the remote points on the surfaces of the microplates and the brightest point of the plasma discharge was less than 0.25.

The two step remote conversion plasma process used according to this example is summarized in Table 2:

**Table 2 - Process parameters for plasma treatment per Example 1**

| Process Step 1-Conditioning Plasma | | Process Step 2-Conversion plasma | |
|---|---|---|---|
| Power (W) | 500 | Power (W) | 500 |
| $O_2$ Flow rate (sccm) | 50 | $H_2O$ Flow rate (sccm) | 5 |
| Time (minutes) | 5 | Time (minutes) | 3 |
| Pressure (mTorr) | 50 | Pressure (mTorr) | 80-120 |

The biomolecule binding resistance resulting from this remote conversion plasma process on the surface of the converted microplates was analyzed by carrying out the Testing of All Embodiments. The percent recovery is the percentage of the original concentration of the protein remaining in solution, i.e., which did not bind to the surface of a microplate.

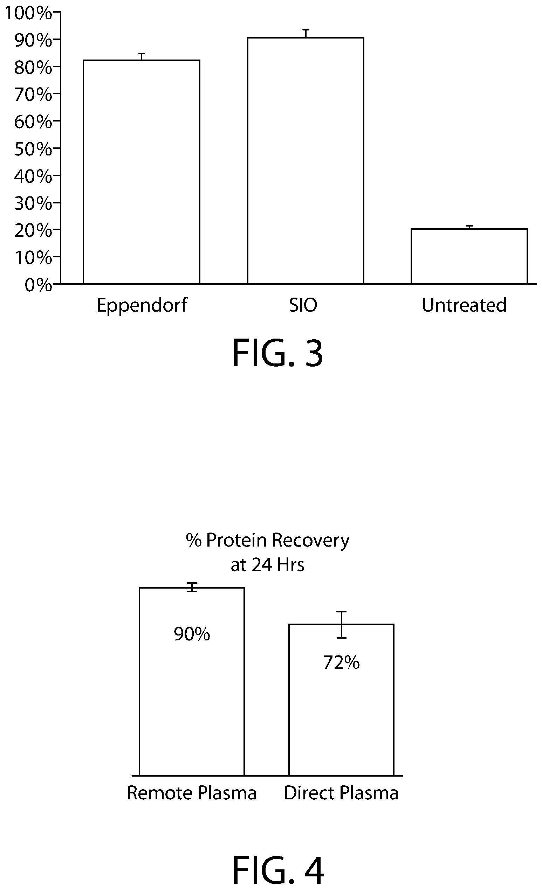

In this testing, samples of three different types of microplates were tested for percent recovery. The samples included: (1) unconditioned and unconverted polypropylene microplates ("Untreated" samples); (2) polypropylene microplates molded by SiO2 Medical Products and converted according to the more detailed embodiment described in Example 1 of this specification ("SiO2" samples); and (3) Eppendorf LoBind® microplates ("EPPENDORF" samples). The bar chart in FIG. 3 shows the results of this comparative testing. As FIG. 3 illustrates, the SiO2 plates had a 60% increase in biomolecule recovery compared to the Untreated Samples and an 8-10% increase in biomolecule recovery compared to the Eppendorf LoBind samples.

Accordingly, remote conversion plasma treatment according to the more detailed embodiment has been demonstrated to result in lower biomolecule adhesion (or the inverse, higher biomolecule recovery) than other known methods. In fact, the comparative data of the SiO2 plates and the Eppendorf LoBind samples were particularly surprising, since Eppendorf LoBind labware has been considered the industry standard in protein resistant labware. The SiO2 plates' 8-10% increase in efficacy compared to the EPPENDORF samples represents a marked improvement compared to the state of the art.

### Example 2 of the more detailed embodiment

In this example, the SiO2 plates of Example 1 were compared to the same microplates that were converted with same process steps and conditions, except (and this is an important exception), the second samples were treated with direct plasma instead of remote conversion plasma (the "Direct Plasma" samples). Surprisingly, as shown in FIG. 4, the Direct Plasma samples had a biomolecule recovery percentage after 24 hours of 72%, while the SiO2 plates (which were converted under the same conditions/process steps except by remote conversion plasma) had a biomolecule recovery percentage after 24 hours of 90%. This remarkable step change demonstrates the unexpected improvement resulting solely from use of remote conversion plasma in place of direct plasma.

**Example 3 of the more detailed embodiment**

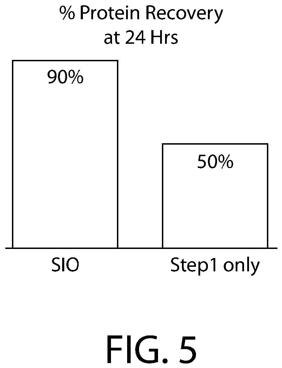

In this example, the SiO2 plates of Example 1 were compared to the same microplates that were treated with only the conditioning step of the method of the more detailed embodiment (i.e., the non-polymerizing compound plasma step or conditioning plasma treatment) without the conversion step (water vapor plasma step or conversion plasma treatment) ("Step 1 Only" samples). As shown in FIG. 5, Step 1 Only samples had a biomolecule recovery percentage after 24 hours at about 25°C (the aging of all protein samples in this specification is at 25°C unless otherwise indicated) of 50%, while the SiO2 plates (which were processed under the same conditions/process steps except also converted by remote conversion plasma) had a biomolecule recovery percentage after 24 hours of 90%. Accordingly, using both steps of the method according to the more detailed embodiment results in significantly improved biomolecule recovery percentage than using only the conditioning step alone.

**Example 4 (prophetic) of the more detailed embodiment**

A further contemplated optional advantage of the more detailed embodiment is that it provides high levels of resistance to biomolecule adhesion without a countervailing high extractables profile. For example, Eppendorf LoBind® labware is resistant to biomolecule adhesion by virtue of a chemical additive, which has a propensity to extract from the substrate and into a solution in contact with the substrate. By contrast, the more detailed embodiment does not rely on chemical additives mixed into a polymer substrate to give the substrate its biomolecule adhesion resistant properties. Moreover, processes according to the more detailed embodiment do not result in or otherwise cause compounds or particles to extract from a converted substrate. Applicant has further determined that the pH protective coating or layer described in this disclosure does not result in or otherwise cause compounds or particles to extract from a converted surface.

Accordingly, in one optional aspect, the more detailed embodiment described herein relates to a method for treating a surface, also referred to as a material or workpiece, to form a converted surface having a biomolecule recovery percentage greater than the biomolecule recovery percentage of the surface prior to conversion treatment, and in which any conditioning or conversion treatment does not materially increase the extractables profile of the substrate. Applicants contemplate that this would bear out in actual comparative tests between the unconditioned and unconverted surface and the converted surface.

**Example 5 of the more detailed embodiment**

A test similar to Example 1 was carried out to compare the biomolecule recovery from unconditioned and unconverted polypropylene (UTPP) laboratory beakers, remote conversion plasma converted polypropylene (TPP) laboratory beakers according to the more detailed embodiment, and unconditioned and unconverted glass laboratory beakers. The biomolecules used were 12 nM dispersions of lyophilized BSA, FBG, TFN, PrA, and PrG.

In a first trial, the biomolecule dispersion was made up in the beaker and aspirated several times to mix it. The biomolecule recovery was measured in relative fluorescence units (RFU). The initial RFU reading (0 min) was taken to establish a 100% recovery baseline, then the biomolecule dispersion in the beaker was stirred for 1 min with a pipet tip, after which it was allowed to remain on the laboratory bench undisturbed for the remainder of the test. The biomolecule recovery was measured initially, and then a sample was drawn and measured for percentage biomolecule recovery at each 5-minute interval. The results are shown in Table 3.

**Table 3 - Polypropylene beaker trial**

| UTPP BSA | | UTPP FBG | | UTPP TFN | | UTPP PrA | | UTPP PrG | |
|---|---|---|---|---|---|---|---|---|---|
| Time (min) | %R | Time (min) | %R | Time (min) | %R | Time (min) | %R | Time (min) | %R |
| 0 | 100% | 0 | 100% | 0 | 100% | 0 | 100% | 0 | 100% |
| 1 | 99% | 1 | 99% | 1 | 98% | 1 | 100% | 1 | 101% |
| 5 | 98% | 5 | 97% | 5 | 94% | 5 | 98% | 5 | 99% |

(continued)

| UTPP BSA | | UTPP FBG | | UTPP TFN | | UTPP PrA | | UTPP PrG | |
|---|---|---|---|---|---|---|---|---|---|
| Time (min) | %R | Time (min) | %R | Time (min) | %R | Time (min) | %R | Time (min) | %R |
| 10 | 99% | 10 | 99% | 10 | 93% | 10 | 99% | 10 | 100% |
| 15 | 98% | 15 | 92% | 15 | 90% | 15 | 97% | 15 | 99% |
| 20 | 99% | 20 | 98% | 20 | 88% | 20 | 98% | 20 | 101% |
| 25 | 99% | 25 | 97% | 25 | 85% | 25 | 96% | 25 | 98% |
| 30 | 98% | 30 | 96% | 30 | 85% | 30 | 96% | 30 | 99% |

| TPP BSA | | TPP FBG | | TPP TFN | | TPP PrA | | TPP PrG | |
|---|---|---|---|---|---|---|---|---|---|
| Time (min) | %R | Time (min) | %R | Time (min) | %R | Time (min) | %R | Time (min) | %R |
| 0 | 100% | 0 | 100% | 0 | 100% | 0 | 100% | 0 | 100% |
| 1 | 104% | 1 | 101% | 1 | 100% | 1 | 104% | 1 | 104% |
| 5 | 104% | 5 | 100% | 5 | 96% | 5 | 104% | 5 | 104% |
| 10 | 106% | 10 | 101% | 10 | 96% | 10 | 104% | 10 | 104% |
| 15 | 104% | 15 | 99% | 15 | 94% | 15 | 102% | 15 | 104% |
| 20 | 106% | 20 | 100% | 20 | 94% | 20 | 104% | 20 | 104% |
| 25 | 103% | 25 | 98% | 25 | 91% | 25 | 102% | 25 | 101% |
| 30 | 105% | 30 | 98% | 30 | 90% | 30 | 103% | 30 | 103% |

A second trial, with results shown in Table 4, was carried out in the same manner as the first trial except that glass beakers, not converted according to the more detailed embodiment, were used as the substrate.

**Table 4 - Glass beaker trial**

| Glass BSA | | Glass FBG | | Glass TFN | | Glass PrA | | Glass PrG | |
|---|---|---|---|---|---|---|---|---|---|
| Time (min) | %R | Time (min) | %R | Time (min) | %R | Time (min) | %R | Time (min) | %R |
| 0 | 100% | 0 | 100% | 0 | 100% | 0 | 100% | 0 | 100% |
| 1 | 100% | 1 | 100% | 1 | 100% | 1 | 105% | 1 | 99% |
| 4 | 99% | 4 | 88% | 4 | 98% | 4 | 103% | 4 | 97% |
| 7 | 100% | 7 | 99% | 7 | 97% | 7 | 104% | 7 | 98% |
| 8 | 98% | 8 | 98% | 8 | 96% | 8 | 102% | 8 | 96% |
| 10 | 98% | 10 | 98% | 10 | 95% | 10 | 100% | 10 | 97% |
| 15 | 96% | 15 | 95% | 15 | 92% | 15 | 100% | 15 | 94% |
| 20 | 97% | 20 | 96% | 20 | 92% | 20 | 101% | 20 | 93% |
| 25 | 96% | 25 | 93% | 25 | 88% | 25 | 95% | 25 | 91% |
| 30 | 94% | 30 | 93% | 30 | 87% | 30 | 98% | 30 | 92% |

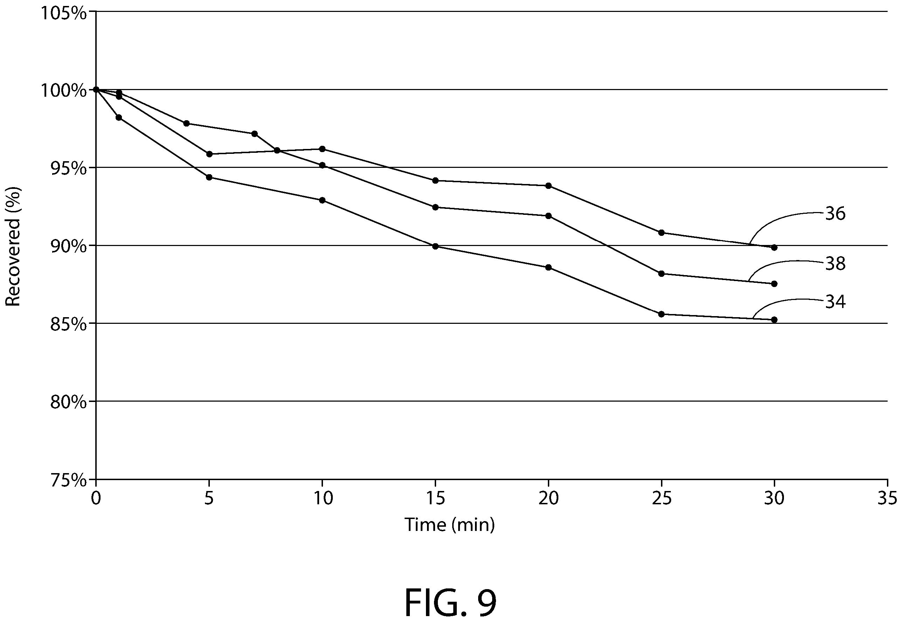

FIG. 9 plots the TFN results in the Tables above, showing plots 34 for the unconditioned and unconverted polypropylene beaker, 36 for the converted polypropylene beaker, and 38 for glass. As FIG. 9 shows, the converted polypropylene beaker provided the highest biomolecule recovery after 10 to 30 minutes, glass produced a lower biomolecule recovery after 10 to 30 minutes, and the unconditioned and unconverted polypropylene beaker provided the lowest biomolecule recovery at all times after the initial measurement.

**Example 6 of the more detailed embodiment**

A test similar to Example 1 was carried out to compare the biomolecule recovery from multiwell polypropylene plates of two types, versus protein concentration, after 24 hours of contact between the protein and the plate. "SiO2" plates were molded from polypropylene and plasma converted according to Example 1. "CA" (Competitor A) plates were commercial competitive polypropylene plates provided with a coating to provide reduced non-specific protein binding.

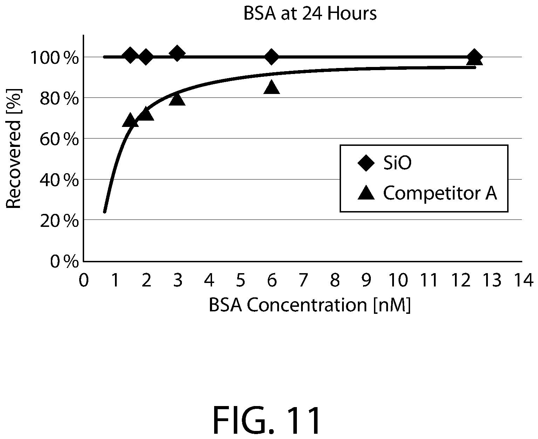

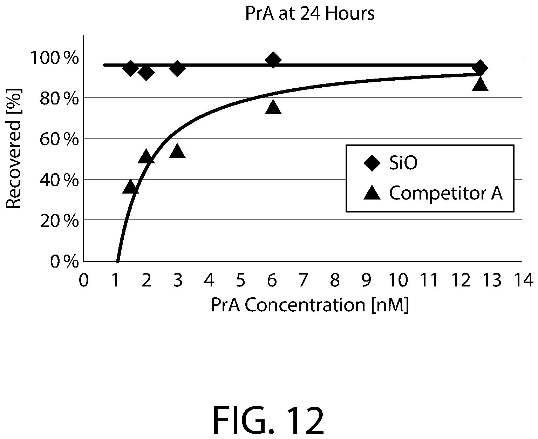

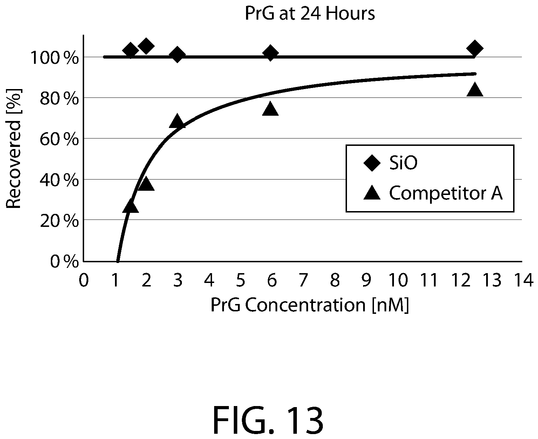

The results are provided in Table 5 and FIGS. 11-13 showing that essentially all the protein of each type was recovered from the converted SiO2 plates at all tested concentrations, so the recovery was independent of concentration. In contrast, the protein recovery from the CA plates depended strongly on the concentration, particularly at lower concentrations.

### Table 5

#### RECOVERY@24 hrs. in %
(96-Well 1000 μL Deep Well Plate)

| Concentration (nM) | Plate | BSA | PrA | PrG |
|---|---|---|---|---|
| 1.5 | SiO2 | 101 | 94 | 103 |
| 2 | SiO2 | 100 | 92 | 105 |
| 3 | SiO2 | 102 | 94 | 101 |
| 6 | SiO2 | 100 | 98 | 102 |
| 12.5 | SiO2 | 100 | 94 | 104 |
| 1.5 | CA | 70 | 37 | 27 |
| 2 | CA | 73 | 52 | 38 |
| 3 | CA | 80 | 54 | 69 |
| 6 | CA | 86 | 76 | 75 |
| 12.5 | CA | 100 | 87 | 84 |

**Example 7 of the more detailed embodiment**

A test similar to Example 1 was carried out to compare the biomolecule recovery from converted "SiO2" plates and "CA" plates of the types described in Example 6. The biomolecules used were 1.5 or 3 nM dispersions of lyophilized BSA, FBG, TFN, PrA, and PrG.

The conditions and results are shown in Table 6. For the BSA, PrA, PrG, and TFN proteins, the converted SiO2 plates provided substantially superior protein recovery, compared to the CA plates. For the FBG protein, the converted SiO2 plates provided better protein recovery than the CA plates.

### Table 6

#### RECOVERY@ 72 hrs. in %
(96 Well 350 μL (SiO) or 500 μL (CA) Shallow Plate)

| Concentration (nM) | Plate | BSA | FBG | TFN | PrA | PrG |
|---|---|---|---|---|---|---|
| 1.5 | SiO2 | 104 | 85 | 79 | 99 | 101 |
| 3 | SiO2 | 100 | 85 | 71 | 93 | 98 |
| 1.5 | CA | 69 | 77 | 45 | 44 | 39 |
| 3 | CA | 74 | 83 | 38 | 60 | 66 |

**Example 8 of the more detailed embodiment**

A test similar to Example 7 was carried out to compare 96-well, 500 μL SiO2 and CA plates. The conditions and results are shown in Table 7. For the BSA, PrA, PrG, and TFN proteins, as well as the 1.5 nM concentration of FBG, the converted SiO2 plates provided substantially superior protein recovery, compared to the CA plates. The 3 nM concentration of FBG was anomalous.

**Table 7**

**RECOVERY@ 72 hrs. in %**

(96 Well 500 µL Deep Well Plate)

| Concentration (nM) | Plate | BSA | FBG | TFN | PrA | PrG |
|---|---|---|---|---|---|---|
| 1.5 | SiO2 | 101 | 85 | 68 | 93 | 104 |
| 3 | SiO2 | 96 | 74 | 71 | 91 | 104 |
| 1.5 | CA | 69 | 77 | 45 | 44 | 39 |
| 3 | CA | 74 | 83 | 38 | 60 | 66 |

**Example 9 of the more detailed embodiment**

A test similar to Example 7 was carried out to compare 96-well, 1000 µL converted SiO2 and CA plates. The conditions and results are shown in Table 8. For the BSA, PrA, and PrG proteins, the converted SiO2 plates provided substantially superior protein recovery, compared to the CA plates. The FBG proteins did not demonstrate substantially superior protein recovery.

**Table 8**

**RECOVERY@ 72 hrs. in %**

(96 Well 1000 µL Deep Well Plate)

| Concentration (nM) | Plate | BSA | FBG | TFN | PrA | PrG |
|---|---|---|---|---|---|---|
| 1.5 | SiO2 | 101 | 51 | 64 | 99 | 100 |
| 3 | SiO2 | 99 | 63 | 62 | 99 | 102 |
| 1.5 | CA | 84 | 76 | 44 | 38 | 44 |
| 3 | CA | 81 | 83 | 46 | 63 | 52 |

**Example 10 of the more detailed embodiment**

A test similar to Example 7 was carried out to compare 384-well 55 µL (converted SiO2) vs 200 µL (CA) shallow plates. The conditions and results are shown in Table 9. For the BSA, PrA, and PrG proteins, the converted SiO2 plates provided substantially superior protein recovery, compared to the CA plates. The FBG proteins did not demonstrate substantially superior protein recovery.

**Table 9**

**RECOVERY@ 72 hrs. in %**

(384 Well 55 µL (SiO2) or 200 µL (CA) Shallow Plate)

| Concentration (nM) | Plate | BSA | FBG | TFN | PrA | PrG |
|---|---|---|---|---|---|---|
| 1.5 | SiO2 | 97 | 38 | 92 | 71 | 102 |
| 3 | SiO2 | 102 | 57 | 87 | 92 | 104 |
| 1.5 | CA | 34 | 58 | 32 | 27 | 14 |
| 3 | CA | 63 | 62 | 39 | 37 | 28 |

**Example 11 of the more detailed embodiment**

A test similar to Example 1 was carried out to compare the SiO2 converted plates of the more detailed embodiment to polypropylene plates treated with StabilBlot® BSA Blocker, a commercial treatment used to reduce BSA protein adhesion, sold by SurModics, Inc., Eden Prairie, MN, USA. The conditions and results are shown in Table 10, where converted SiO2 is the plate according to Example 1, Plate A is a polypropylene plate treated with 5% BSA blocker for one hour and Plate B is a polypropylene plate treated with 1% BSA blocker for one hour. Except for FBG protein, the present invention again provided superior results compared to the BSA blocker plates.

**Table 10**

**RECOVERY @ 24 hrs. in %**

(3 nM in buffer)

| Concentration (nM) | Plate | BSA | FBG | TFN | PrA | PrG |
|---|---|---|---|---|---|---|
| 3 | SiO2 | 102 | 69 | 79 | 96 | 104 |
| 3 | A | 97 | 85 | 71 | 93 | 102 |
| 3 | B | 94 | 84 | 66 | 70 | 75 |

A: 5% BSA blocker passivation of 1000 μL, treated 1hr;

B: 1% BSA blocker passivation of 1000 μL, treated 1hr;

**Example 12 of the more detailed embodiment**

A test similar to Example 7 was carried out to compare the protein recovery rates of SiO2 converted plates in accordance with Example 1 over longer periods of time - from 1 to 4 months. The conditions and results are shown in Table 11, which illustrates that roughly uniform resistance to protein adhesion was observed for all of the proteins over a substantial period.

**Table 11**

**RECOVERY in %**

| Time (month) | BSA | FBG | TFN | PrA | PrG |
|---|---|---|---|---|---|
| Initial | 97 | 80 | 63 | 98 | 101 |
| 1 | 95 | - | 66 | 81 | 100 |
| 2 | 94 | 85 | 61 | 87 | 96 |
| 3 | 92 | 77 | 79 | 87 | 94 |
| 4 | 97 | 74 | 77 | 85 | 94 |

**Example 13 of the more detailed embodiment**

The uniformity of binding among the different wells of a single plate was tested using two 96-well plates with deep (500 μL) wells, a converted SiO2 plate prepared according to Example 1 except testing 2nM PrA protein after two hours in all 96 wells, and the other a Competitor A plate, again testing 2nM PrA protein after two hours in all 96 wells. The protein recovery from each well on one plate was measured, then averaged, ranged (determining the highest and lowest recovery rates among the 96 wells), and a standard deviation was calculated. For the converted SiO2 plate, the mean recovery was 95%, the range of recoveries was 11%, and the standard deviation was 2%. For the CA plate, the mean recovery was 64%, the range of recoveries was 14%, and the standard deviation was 3%.

The same test as in the preceding paragraph was also carried out using 96-well plates with 1000 μL wells. For the converted SiO2 plate, the mean recovery was 100%, the range of recoveries was 13%, and the standard deviation was 3%. For the CA plate, the mean recovery was 62%, the range of recoveries was 25%, and the standard deviation was 3%.

This testing indicated that the conversion treatment of Example 1 allows at least as uniform a recovery rate among the different wells as the protein resisting coating of the CA plate. This suggests that the SiO2 plasma treatment is very uniform across the plate.

**Example 14 of the more detailed embodiment**

This example was carried out to compare the protein recovery from multiwell polypropylene plates of two types versus protein concentration, after 96 hours of contact between the protein and the plate. SiO2 plates were molded from polypropylene and plasma converted according to Example 6. "EPP" plates were commercial competitive polypropylene Eppendorf LoBind® plates. The testing protocol is the same as in Example 6, except that the smallest protein concentrations -- 0.1 nM -- were much lower than those in Example 6.

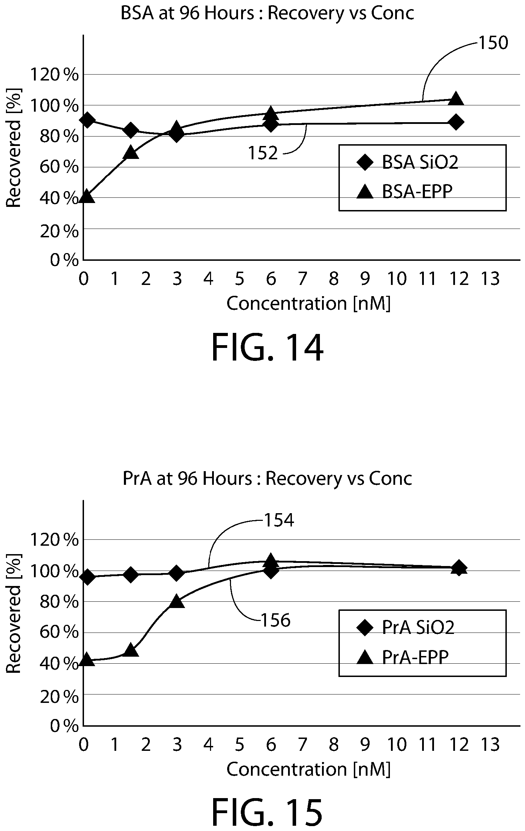

The results are shown in Table 12 and FIGS. 14-16. In fact, the comparative data of the converted SiO2 plates (plots 152, 154, and 158) and the Eppendorf LoBind® plates (i.e. "EPP" plates, plots 150, 156, and 160) were particularly surprising, since Eppendorf LoBind® has been considered the industry standard in protein resistant labware. For all three types of proteins tested in the example (i.e. BSA, PrA and PrG), the protein recovery was substantially constantly high regardless of the concentration for converted SiO2 plates. However, for "EPP" plates, the protein recovery was dramatically lowered at low concentration. Especially at ultra-low concentration (e.g. from 0.1 nM to less than 1.5 nM), the protein recoveries for the SiO2 converted plates were far superior to the "EPP" plate.

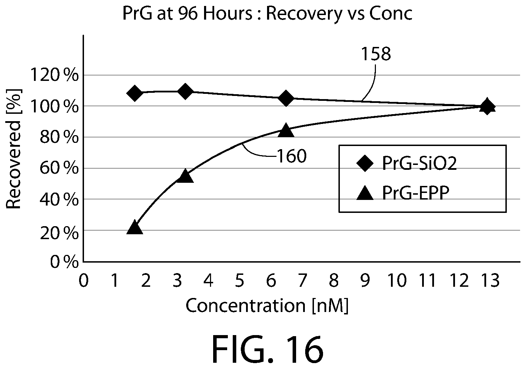

For the PrG protein as shown by data marked with asterisks in Table 12, the 0.1 nM SiO2 converted plate data point was regarded as anomalous, since the true protein recovery of the SiO2 converted plate cannot exceed 100% plus the error limit assigned to the data point. The 0.1 nM EPP Plate PrG data point also was regarded as anomalous, since it deviates substantially from the trend of the other data points. These anomalous data points are not shown in FIG. 16.

### Table 12

#### RECOVERY @ 96hrs in %
(96-Well 500 $\mu$L Deep Well Plate)

| Concentration (nM) | Plate | BSA | PrA | PrG |
|---|---|---|---|---|
| 0.1 | SiO2 | 91 | 95 | 216* |
| 1.5 | SiO2 | 84 | 97 | 109 |
| 3 | SiO2 | 81 | 98 | 109 |
| 6 | SiO2 | 87 | 106 | 105 |
| 12 | SiO2 | 89 | 101 | 100 |
| 0.1 | EPP | 42 | 42 | 85* |
| 1.5 | EPP | 68 | 48 | 23 |
| 3 | EPP | 85 | 80 | 56 |
| 6 | EPP | 95 | 100 | 85 |
| 12 | EPP | 104 | 102 | 100 |

**Example 15 of the more detailed embodiment**

Characterization of Extracted Organic Species from the present Low Protein Binding Converted Microplates Using GC-MS Method

This testing was carried out on a 96-well microplate to evaluate if the present conversion treatment adds extractables to the solution in contact with the substrate. The microplate was molded from polypropylene and converted with plasma according to Example 6.

Extraction Procedures

300 $\mu$L isopropanol (IPA) was added to a total of 16 wells in the 96-well microplate. After the addition, the plate was covered firmly with a glass plate and stored at room temperature for 72 hours. Following extraction, the contents of the 16 wells were combined in one individual vial, capped, and inverted to mix. Individual aliquots were transferred to autosampler vials for GC-MS analyses.

GC-MS Analysis Conditions and Results

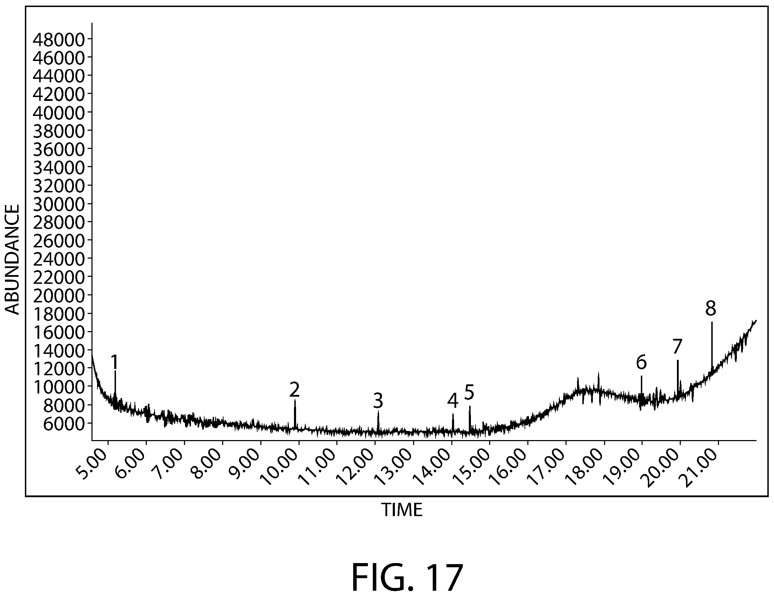

The GC-MS (gas chromatography - mass spectrometry) analysis conditions are shown in Table 13 and a resulting plot, annotated with the eight peak assignments made, is shown in FIG. 17 and the peak assignments are described in Table 14.

### Table 13

#### GC-MS Conditions

| | |
|---|---|
| Capillary Column | DB - 5MS, 30 m x 0.25 mm I.D. x 0.25 $\mu$m |
| Inlet | 300 °C |
| Carrier Gas (He) Flow | 1.0 mL/minute constant flow |
| Injection | 1 $\mu$L splitless injection |
| Temperature Program | 50 °C increased at 10 °C /min to 300 °C (10 min hold) |
| Transfer Line | 300 °C |
| Detector | Agilent 5973 MSD, Scan Mode m/z 33-700 |

**Table 14**

| Extract Peaks For SiO2 Plates | |
|---|---|
| **Peak #, FIG. 17** | **Compound Identification** |
| 1 | Siloxane (seen in blank) |
| 2 | Siloxane (seen in blank) |
| 3 | Siloxane (seen in blank) |
| 4 | Siloxane (seen in blank) |
| 5 | Unknown (seen in blank) |
| 6 | Aliphatic hydrocarbon (seen in blank) |
| 7 | Aliphatic hydrocarbon (seen in blank) |
| 8 | Aliphatic hydrocarbon (seen in blank) |

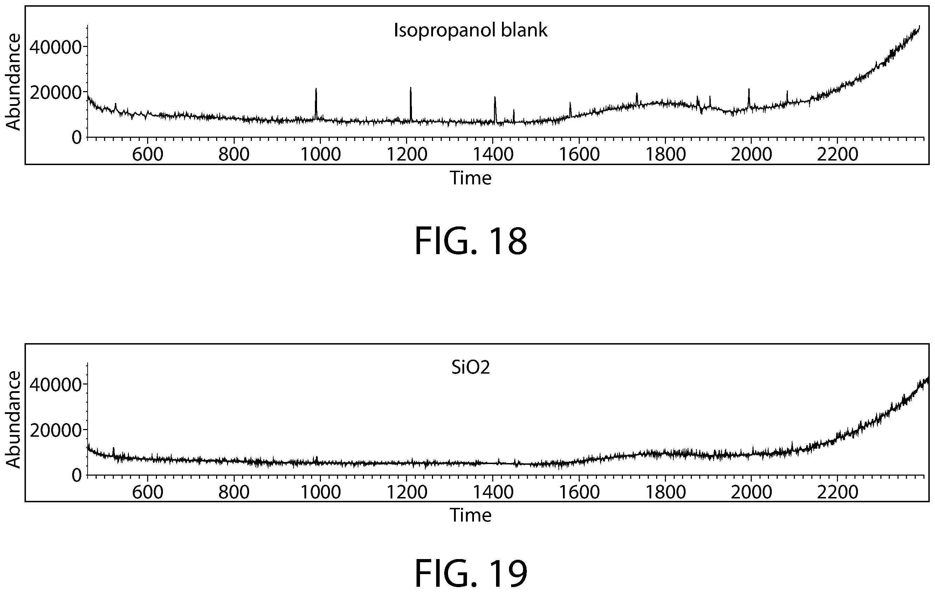

FIGS. 18 and 19 show the GC-MS plots, measured in the same way as FIG. 17, characterizing extracted organic species for an isopropanol blank (FIG. 18) vs. the converted SiO2 low protein binding treated microplates according to Example 15 (FIG. 19).

**Example 16 of the more detailed embodiment**

Characterization of Extracted Organic Species from SiO2 Low Protein Binding Converted Microplates Using LC-MS Method

An LC-MS (liquid chromatography - mass spectroscopy) method was used to analyze the organic extractables and evaluate if the present conversion treatment adds organic extractables to the solution in contact with the substrate. Extraction procedures are the same as in Example 15.

LC-MS Analysis Conditions and Results

Analyses were conducted with an Agilent G6530A Q-TOF mass spectrometer and extracts were run in both positive and negative APCI modes. The LC-MS conditions for positive APCI are shown in Table 15 and the LC-MS conditions for negative APCI are shown in Table 16.

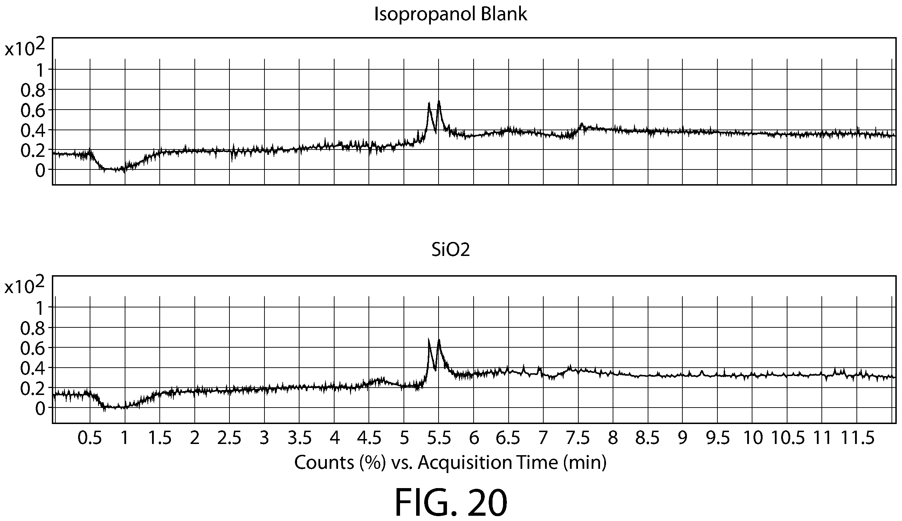

FIG. 20 shows the comparison of the LC-MS isopropanol extracted ion chromatogram (positive APCI mode) of the SiO2 low protein binding converted plates (lower plot) vs that of the isopropanol blank (upper plot).

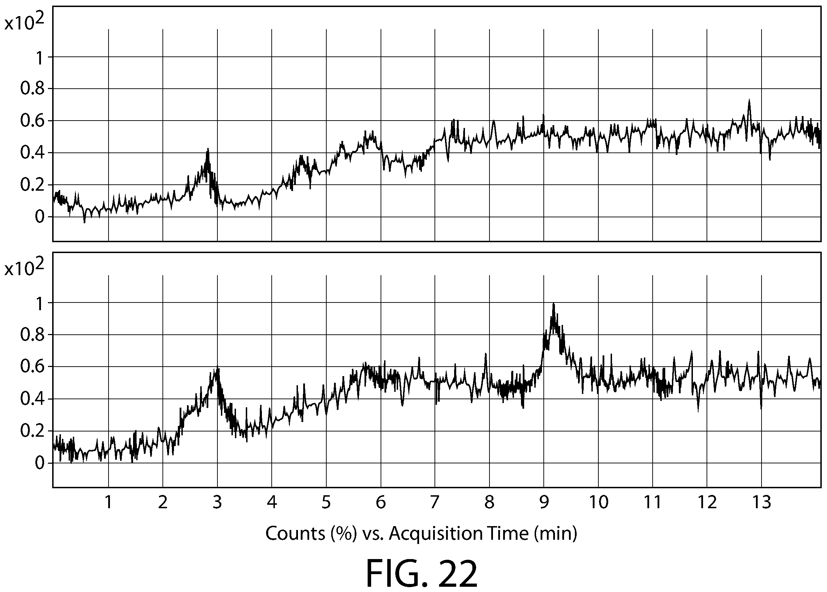

FIG. 22 shows the comparison of the LC-MS isopropanol extracted ion chromatogram (negative APCI mode) of the SiO2 low protein binding converted plates (lower plot) vs that of the isopropanol blank (upper plot).

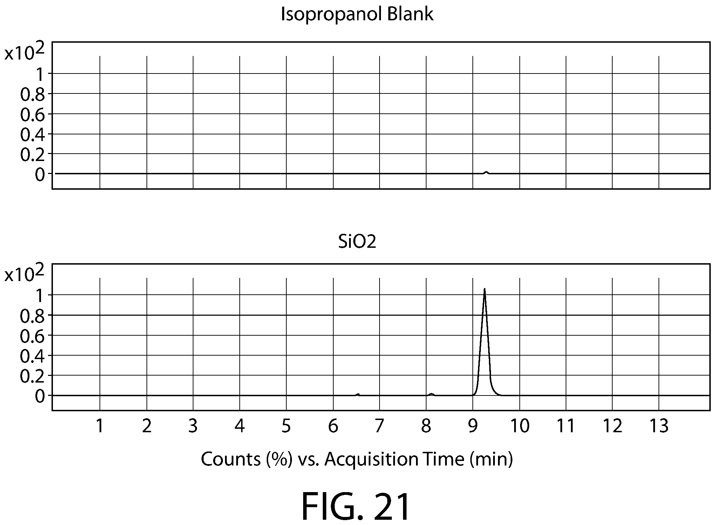

The only unmatched peak for SiO2 converted plates is at m/z 529 which is consistent with Irganox® 1076 in the unconditioned and unconverted SiO2 plates' isopropanol extract (FIG. 21, lower plot), vs. an isopropanol blank (upper plot). Therefore, this extracted compound was not added by the present low protein binding treatment. It came from the resin, as it also was extracted from unconditioned and unconverted SiO2 plates.

**Table 15**

| LC-MS Conditions For Positive APCI | |
|---|---|
| **Mobile Phase A** | HPLC Grade Water |
| **Mobile Phase B** | HPLC Grade Methanol |
| **Column** | Zorbax Exlipse $C_8$ columns, 2.1 mm x 50 mm, 1.8 $\mu$m |
| **Column Temperature** | 40 °C |
| **Injection Volume** | 3 $\mu$L |
| **Flow Rate** | 0.3 mL/min |

(continued)

| Gradient | Time (min) | %A | %B |
|---|---|---|---|
| | 0.0 | 90.0 | 10.0 |
| | 5.0 | 0.0 | 100.0 |
| | 12.0 | 0.0 | 100.0 |
| Equilibration time | 4 minutes between runs | | |

**Table 16**

| LC-MS Conditions For Negative APCI | | | |
|---|---|---|---|
| Mobile Phase A | HPLC Grade Water | | |
| Mobile Phase B | HPLC Grade Methanol | | |
| Column | Imtakt Cadenza CD-C18 column, 4.6 mm x 30 mm, 3 $\mu$m | | |
| Column Temperature | 40 °C | | |
| Injection Volume | 5 $\mu$L | | |
| Flow Rate | 0.7 mL/min | | |
| Gradient | Time (min) | %A | %B |
| | 0.0 | 40.0 | 60.0 |
| | 6.0 | 0.0 | 100.0 |
| | 14.0 | 0.0 | 100.0 |
| Equilibration time | 4 minutes between runs | | |

**Example 17 of the more detailed embodiment**

Characterization of Extracted Inorganic Species from SiO2 Microplates Using ICP-MS Method

An ICP-MS method was used to compare the inorganic extractable level of three types of 96-well microplates. The three types of microplates are unconditioned and unconverted commercial Labcyte polypropylene microplates (Labcyte), unconditioned and unconverted commercial Porvair polypropylene microplates (Porvair) and SiO2 low binding plasma converted microplates, molded by SiO2 Medical Products, Inc. from polypropylene and converted with plasma according to Example 6.

Extraction Procedures

The wells in the microplates were filled with a 2% v/v nitric acid ($HNO_3$) solution in de-ionized (DI) water, covered with a glass plate, and allowed to extract at room temperature for 72 hours. Then approximately 3 mL of the solution were transferred into autosampler tubes and analyzed by ICP-MS using an Agilent 7700x spectrometer and the conditions are shown in Table 17.

ICP-MS Analysis Conditions and Results

The results are shown in Table 18. The results show that nitric acid extracts of converted SiO2 plates have low levels of inorganics, near equivalent to that of unconditioned and unconverted Labcyte and Porvair plates. Therefore SiO2 Medical Products low protein binding conversion treatment does not add inorganic extractables.

**Table 17**

| ICP-MS Conditions | |
|---|---|
| RF Power | 1550 W |

(continued)

| ICP-MS Conditions | |
|---|---|
| **Plasma Mode** | General Purpose |
| **He Flow** | 4.3 mL/min |
| **Number of Replicates** | 3 |
| **Sweeps/Replicates** | 100 |

**Table 18**

| **Summary of the ICP - MS Elemental Analysis of the Extraction Residues, Including Detection Limit (DL) and Quantitation Limit (QL) Results** | | | | | |
|---|---|---|---|---|---|
| | | **Labcyte** | **SiO2** | **Porvair** | | |
| | **Blank*** | **(S152365)** | **(S152367)** | **(S152368)** | **DL** | **QL** |
| **Element** | μg/L | μg/L | μg/L | μg/L | μg/L | μg/L |
| Aluminum | <DL | 17.0 | 14.3 | 11.4 | 0.023 | 0.077 |
| Antimony | <DL | 0.016 | <DL | 0.015 | 0.003 | 0.009 |
| Arsenic | <DL | <QL | <DL | <DL | 0.024 | 0.081 |
| Barium | <DL | 0.22 | 0.36 | 1.45 | 0.004 | 0.013 |
| Cadmium | <DL | <QL | <QL | <DL | 0.002 | 0.007 |
| Calcium | <DL | 17.9 | 28.5 | 74.0 | 1.743 | 5.809 |
| Chromium | <DL | 0.22 | 0.16 | 2.52 | 0.025 | 0.084 |
| Cobalt | <DL | 0.014 | 0.017 | 0.027 | 0.002 | 0.006 |
| Copper | <DL | 1.67 | 1.67 | 1.01 | 0.257 | 0.856 |
| Gold | 0.013 | 0.011 | 0.011 | 0.015 | 0.001 | 0.003 |
| Iridium | 0.003 | <QL | 0.161 | 0.102 | 0.001 | 0.003 |
| Iron | <DL | 2.39 | 4.52 | 47.5 | 0.040 | 0.134 |
| Lead | <DL | 0.118 | 0.111 | 0.075 | 0.001 | 0.003 |
| Lithium | <DL | 0.03 | 0.03 | 0.05 | 0.008 | 0.026 |
| Magnesium | <DL | 15.8 | 28.5 | 88.0 | 0.007 | 0.023 |
| Mercury | <DL | <DL | <DL | <DL | 1.775 | 5.917 |
| Manganese | <DL | 0.06 | 0.16 | 0.71 | 0.010 | 0.035 |
| Molybdenum | <DL | <QL | 0.03 | 0.21 | 0.004 | 0.013 |
| Nickel | <DL | 0.13 | 0.25 | 0.22 | 0.019 | 0.064 |
| Osmium | 0.018 | 0.014 | 0.014 | 0.014 | 0.002 | 0.008 |
| Palladium | <QL | <QL | 0.010 | 0.009 | 0.002 | 0.007 |
| Platinum | <DL | <DL | <DL | <QL | 0.001 | 0.004 |
| Potassium | <DL | 15.1 | 21.3 | 33.5 | 0.931 | 3.103 |
| Rhodium | 0.002 | <QL | 0.041 | 0.032 | 0.0004 | 0.001 |
| Ruthenium | <DL | <DL | <DL | <DL | 0.002 | 0.006 |
| | | **Labcyte** | **SiO2** | **Porvair** | | |
| | **Blank*** | **(S152365)** | **(S152367)** | **(S152368)** | **DL** | **QL** |
| **Element** | μg/L | μg/L | μg/L | μg/L | μg/L | μg/L |
| Selenium | <DL | <DL | <DL | <DL | 0.128 | 0.426 |

(continued)

|  |  | Labcyte | SiO2 | Porvair |  |  |
|---|---|---|---|---|---|---|
|  | Blank* | (S152365) | (S152367) | (S152368) | DL | QL |
| Element | μg/L | μg/L | μg/L | μg/L | μg/L | μg/L |
| Silver | 0.002 | 0.001 | 0.003 | 0.003 | 0.0003 | 0.001 |
| Sodium | <QL | 264 | 469 | 433 | 0.063 | 0.210 |
| Thallium | <DL | <QL | <QL | <DL | 0.0002 | 0.001 |
| Tin | <DL | <QL | <DL | <QL | 0.025 | 0.082 |
| Vanadium | <DL | 0.008 | 0.010 | 0.050 | 0.002 | 0.005 |
| Zinc | <DL | 3.24 | 10.5 | 6.10 | 0.030 | 0.099 |
| *The results were not corrected for the procedural blank reported in the first column | | | | | | |

**Claims**

1. A method for treating a surface of a plastic substrate, the method comprising:

    optionally, a conditioning plasma treatment carried out by treating a surface of a plastic substrate with conditioning plasma of one or more non-polymerizing compounds generated at a remote point from the surface, where the ratio of the radiant energy density at the remote point to the radiant energy density at the brightest point of the conditioning plasma is less than 0.5, optionally less than 0.25, forming a conditioned surface; and
    a conversion plasma treatment carried out by treating the conditioned surface (if the optional step is performed) or unconditioned surface (if the optional step is omitted) with conversion plasma of water vapor, the conversion plasma being generated at a remote point from the conditioned surface, where the ratio of the radiant energy density at the remote point of conversion plasma treatment to the radiant energy density at the brightest point of the conversion plasma is less than 0.5, optionally less than 0.25, wherein the radiant energy density at the brightest point of the plasma is determined spectrophotometrically by measuring the radiant intensity of the most intense emission line of light in the spectrum from 380 nm to 750 nm wavelength at the brightest point, and the radiant energy density at the remote point is determined spectrophotometrically by measuring the radiant energy density of the same emission line of light at the remote point,
    to form a converted surface having a biomolecule recovery percentage, for an aqueous protein dispersion having a concentration from 0.01 nM to 1.4 nM, optionally 0.05 nM to 1.4 nM, optionally 0.1 nM to 1.4 nM, in contact with the converted surface, greater than 80%, wherein the biomolecule recovery percentage is determined according to the method "Testing of all embodiments" described in the description.

2. The method of claim 1, wherein the surface is a vessel lumen surface.

3. The method of any one preceding claim, wherein the converted surface has a biomolecule recovery percentage greater than the biomolecule recovery percentage of the unconditioned and unconverted surface for at least one of mammal serum albumin; Bovine Serum Albumin (BSA); Fibrinogen (FBG); Transferrin (TFN); egg white ovotransferrin (conalbumin); membrane-associated melanotransferrin; Protein A (PrA); Protein G (PrG); Protein A/G; Protein L; Insulin; Pharmaceutical protein; blood component proteins; and any recombinant form, modification, full length precursor, signal peptide, propeptide, or mature variant of these proteins.

4. The method of any one preceding claim, wherein the surface comprises a thermoplastic material.

5. The method of any one preceding claim, wherein the surface comprises olefin polymer, polypropylene (PP), polyethylene (PE), cyclic olefin copolymer (COC), cyclic olefin polymer (COP), polymethylpentene, polyester, polyethylene terephthalate, polyethylene naphthalate, polybutylene terephthalate (PBT), polyvinylidene chloride (PVdC), polyvinyl chloride (PVC), polycarbonate, polylactic acid, polystyrene, hydrogenated polystyrene, polycyclohexylethylene (PCHE), epoxy resin, nylon, polyurethane polyacrylonitrile, polyacrylonitrile (PAN), an ionomeric resin, or any combination, composite or blend of any two or more of these materials.

**6.** The method of any one preceding claim wherein the conditioning plasma treatment and/or conversion plasma treatment are carried out using plasma excited by extremely low frequency (ELF) of 3 to 30 Hz, super low frequency (SLF) of 30 to 300 Hz, voice or ultra-low frequency (VF or ULF) of 300 Hz to 3kHz, very low frequency (VLF) of 3 to 30 kHz, low frequency (LF) of 30 to 300 kHz, medium frequency (MF) of 300 kHz to 3 MHz, high frequency (HF) of 3 to 30 MHz, very high frequency (VHF) of 30 to 300 MHz, ultra-high frequency (UHF) of 300 MHz to 3 GHz, or any combination of two or more of these.

**7.** The method of any one preceding claim, in which the surface is a coating or layer of PECVD deposited $SiO_xC_yH_z$ or $SiN_xC_yH_z$, in which x is from about 0.5 to about 2.4 as measured by X-ray photoelectron spectroscopy (XPS), y is from about 0.6 to about 3 as measured by XPS, and z is from about 2 to about 9 as measured by Rutherford backscattering spectrometry (RBS); or a barrier coating or layer of $SiO_x$, in which x is from about 1.5 to about 2.9 as measured by XPS, or an oxide or nitride made from an organometallic precursor that is a compound of a metal element from Group III and/or Group IV of the Periodic Table, e.g. in Group III: Boron, Aluminum, Gallium, Indium, Thallium, Scandium, Yttrium, or Lanthanum, (Aluminum and Boron being preferred), and in Group IV: Silicon, Germanium, Tin, Lead, Titanium, Zirconium, Hafnium, or Thorium (Silicon and Tin being preferred).

**8.** The method of any one preceding claim, wherein the surface is a fluid contact surface of an article of labware, preferably of a microplate, a centrifuge tube, a pipette tip, a well plate, a microwell plate, an ELISA plate, a microtiter plate, a 96-well plate, a 384-well plate, a vial, a bottle, a jar, a syringe, a cartridge, a blister package, an ampoule, an evacuated blood collection tube, a specimen tube, or a chromatography vial.

**9.** The method of any one preceding claim, comprising the preliminary step of treating the surface with the conditioning plasma, the conditioning plasma comprising: a nitrogen-containing gas, an inert gas, an oxidizing gas, or a combination of two or more of these, forming the conditioned surface.

**10.** The method of any one preceding claim, further comprising the preliminary step of treating the surface with ionized gas comprising: air, oxygen, an inert gas, a nitrogen-containing gas, for example nitrogen, nitrous oxide, nitrogen dioxide, nitrogen tetroxide, ammonia; or a combination of any two or more of these.

**11.** The method of any one of claims 1 to 9 comprising the steps of:

applying ionized gas to the surface, and
creating the conditioning plasma at the surface, and
creating the conversion plasma at the surface.

**12.** The method of claim 11, where the ionized gas is any inert gas, any oxidizing gas or any nitrogen containing gas, and preferably where the ionized gas is air.

**13.** The method of claim 11 or 12 where the conditioning plasma is nitrogen.

**14.** An article resulting from the method as described in any one preceding claim.

**Patentansprüche**

**1.** Ein Verfahren zur Behandlung einer Oberfläche eines Plastik-Substrats, das Verfahren umfassend:

eine optionale konditionierende Plasmabehandlung, durchgeführt mittels Behandlung einer Oberfläche eines Plastik-Substrats mit konditionierendem Plasma aus einer oder mehreren nicht-polymerisierenden Verbindungen, welches an einem von der Oberfläche entfernten Punkt erzeugt wird, wobei das Verhältnis der Strahlungsenergiedichte am entfernten Punkt zur Strahlungsenergiedichte am hellsten Punkt des konditionierenden Plasmas weniger als 0,5 beträgt, optional weniger als 0,25, wodurch eine konditionierte Oberfläche gebildet wird; und
eine Behandlung mit Konversionsplasma, durchgeführt mittels Behandlung der konditionierten Oberfläche (falls der optionale Behandlungsschritt durchgeführt wird) oder der unkonditionierten Oberfläche (falls der optionale Behandlungsschritt ausgelassen wird) mit Konversionsplasma aus Wasserdampf, wobei das Konversionsplasma an einem von der konditionierten Oberfläche entfernten Punkt erzeugt wird, wobei das Verhältnis der Strahlungsenergiedichte am entfernten Punkt der Konversionsplasma-Behandlung zur Strahlungsenergiedichte am hellsten Punkt des Konversionsplasmas weniger als 0,5 beträgt, optional weniger als 0,25, wobei Strahlungsenergiedichte am hellsten Punkt des Plasmas spektrophotometrisch ermittelt wird durch Messung der Strahlungsintensität der intensivsten Lichtemissionslinie innerhalb des Spektrums von einer Wellenlänge von 380 nm bis 750 nm am hellsten Punkt, und die Strahlungsenergiedichte am entfernten Punkt spektrophotometrisch ermittelt wird durch Messung der Strahlungsenergiedichte derselben Lichtemissionslinie am entfernten Punkt,

wodurch eine konvertierte Oberfläche erzeugt wird, welche eine prozentuale Biomolekülrückgewinnungsrate für eine wässrige Proteindispersion mit einer Konzentration von 0,01 nm bis 1,4 nm, optional 0,05 nm bis 1,4 nm, optional 0,1 nm bis 1,4 nm in Kontakt mit der konvertierten Oberfläche von höher als 80% aufweist, wobei die prozentuale Biomolekülrückgewinnungsrate bestimmt wird gemäß der Methode "Testing of all embodiments", welche in der Beschreibung beschrieben wird.

2.  Das Verfahren gemäß Anspruch 1, wobei die Oberfläche eine Oberfläche eines Gefäßlumens ist.

3.  Das Verfahren gemäß irgendeinem vorhergehenden Anspruch, wobei die konvertierte Oberfläche eine prozentuale Biomolekülrückgewinnungsrate hat, welche höher ist als die prozentuale Biomolekülrückgewinnungsrate der unkonditionierten und unkonvertierten Oberfläche für mindestens eines aus: Säugetier-Serumalbumin; Bovines Serumalbumin (BSA); Fibrinogen (FBG); Transferrin (TFN); Eiweiß-Ovotransferrin (Conalbumin); Membraneassoziiertes Melanotransferrin; Protein A (PrA); Protein G (PrG); Protein A/G; Protein L; Insulin; Pharmazeutisches Protein; Protein-Blutkomponenten; und jegliche rekombinante Form, Modifikation, Volllänge-Vorstufe, jegliches Signalpeptid, Propeptid, oder jegliche reife Variante dieser Proteine.

4.  Das Verfahren gemäß irgendeinem vorhergehenden Anspruch, wobei die Oberfläche ein thermoplastisches Material umfasst.

5.  Das Verfahren gemäß irgendeinem vorhergehenden Anspruch, wobei die Oberfläche Olefinpolymer, Polypropylen (PP), Polyethylen (PE), zyklisches Olefincopolymer (COC), zyklisches Olefinpolymer (COP), Polymethylpenten, Polyester, Polyethylenterephthalat, Polyethylennaphthalat, Polybutylenterephthalat (PBT), Polyvinylidenchlorid (PVdC), Polyvinylchlorid (PVC), Polycarbonat, Polymilchsäure, Polystyrol, hydriertes Polystyrol, Polycyclohexylethylen (PCHE), Epoxidharz, Nylon, Polyurethanpolyacrylnitril, Polyacrylnitril (PAN), ein ionomeres Harz, oder irgendeine Kombination, irgendein Komposit, oder irgendeine Mischung aus beliebigen zwei oder mehr von diesen Materialien umfasst.

6.  Das Verfahren gemäß irgendeinem vorhergehenden Anspruch, wobei die konditionierende Plasmabehandlung und/oder Konversionsplasmabehandlung ausgeführt werden unter Verwendung von Plasma das angeregt wird durch eine extrem niedrige Frequenz (ELF) von 3 bis 30 Hz, eine super-niedrige Frequenz (SLF) von 30 bis 300 Hz, eine Stimm- oder ultra-niedrige Frequenz (VF oder ULF) von 300 Hz bis 3kHz, eine sehr niedrige Frequenz (VLF) von 3 bis 30 kHz, eine Niederfrequenz (LF) von 30 bis 300 kHz, Mittelfrequenz (MF) von 300 kHz bis 3 MHz, Hochfrequenz (HF) von 3 bis 30 MHz, sehr hohe Hochfrequenz (VHF) von 30 bis 300 MHz, Ultrahochfrequenz (UHF) von 300 MHz bis 3 GHz, oder irgendeine Kombination aus zweien oder mehreren von diesen Frequenzen.

7.  Das Verfahren gemäß irgendeinem vorhergehenden Anspruch, wobei die Oberfläche ein Coating oder eine Schicht aus PECVD-abgeschiedenem $SiO_xC_yH_z$ oder $SiN_xC_yH_z$ ist, worin x von etwa 0,5 bis etwa 2,4 beträgt, gemessen durch X-Ray Photoelectron Spectroscopy (XPS), y von etwa 0,6 bis etwa 3 beträgt, gemessen durch XPS, und z von etwa 2 bis etwa 9 beträgt, gemessen durch Rutherford-Backscattering-Spectrometry (RBS); oder ein Barrierecoating oder eine Schicht aus $SiO_x$ ist, worin x von etwa 1,5 bis etwa 2,9 beträgt, gemessen durch XPS, oder ein Oxid oder Nitrid ist, welches hergestellt wurde aus einer metallorganischen Vorstufe, welche eine Verbindung eines Elementmetalls aus Gruppe III und/oder Gruppe IV des Periodensystems ist, z.B. in Gruppe III: Bor, Aluminium, Gallium, Indium, Thallium, Scandium, Yttrium, oder Lanthan, (wobei Aluminium und Bor bevorzugt sind), und in Gruppe IV: Silicium, Germanium, Zinn, Blei, Titanium, Zirkonium, Hafnium, oder Thorium (wobei Silicium und Zinn bevorzugt sind).

8.  Das Verfahren gemäß irgendeinem vorhergehenden Anspruch, wobei die Oberfläche eine Oberfläche mit Flüssigkeitskontakt eines Laborbedarf-Artikels, vorzugsweise einer Mikroplatte, eines Zentrifugenröhrchens, einer Pipettenspitze, einer Well-Platte, einer Microwell-Platte, einer ELISA-Platte, einer Mikrotiterplatte, einer 96-well-Platte, einer 384-well-Platte, eines Fläschchens, einer Flasche, eines Tiegels, einer Spritze, einer Kartusche, einer Blisterpackung, einer Ampulle, eines evakuierten Blutprobenröhrchens, eines Probenröhrchens, oder eines Chromatographiefläschchens.

**9.** Das Verfahren gemäß irgendeinem vorhergehenden Anspruch, umfassend den einleitenden Schritt der Behandlung der Oberfläche mit dem konditionierenden Plasma, wobei das konditionierende Plasma umfasst: ein stickstoffhaltiges Gas, ein Inertgas, ein oxidierendes Gas, oder eine Kombination aus zweien oder mehreren davon, wodurch die konditionierte Oberfläche gebildet wird.

**10.** Das Verfahren gemäß irgendeinem vorhergehenden Anspruch, außerdem umfassend den einleitenden Schritt der Behandlung der Oberfläche mit ionisiertem Gas umfassend: Luft, Sauerstoff, ein Inertgas, ein stickstoffhaltiges Gas, zum Beispiel Stickstoff, Lachgas, Stickstoffdioxid, Stickstofftetroxid, Ammoniak; oder eine Kombination aus beliebigen zweien oder mehreren davon.

**11.** Das Verfahren gemäß irgendeinem der Ansprüche 1 bis 9, umfassend die Schritte:

Leiten von ionisiertem Gas auf die Oberfläche, und
Erzeugen des konditionierenden Plasmas an der Oberfläche, und
Erzeugen des Konversionsplasmas an der Oberfläche.

**12.** Das Verfahren gemäß Anspruch 11, wobei das ionisierte Gas irgendein Inertgas, irgendein oxidierendes Gas, oder irgendein stickstoffhaltiges Gas ist, und wobei das ionisierte Gas bevorzugt Luft ist.

**13.** Das Verfahren gemäß Anspruch 11 oder Anspruch 12, wobei das konditionierende Plasma Stickstoff ist.

**14.** Ein Artikel, welcher das Produkt des in irgendeinem der vorhergehenden Ansprüche beschriebenen Verfahrens ist.

**Revendications**

**1.** Procédé de traitement de surface d'un substrat en matière plastique, le procédé comprenant :

éventuellement, un traitement de conditionnement par plasma réalisé en traitant une surface d'un substrat en matière plastique avec un plasma de conditionnement d'un ou de plusieurs composés non polymérisants générés à un point éloigné de la surface, où le ratio de la densité d'énergie radiante au point éloigné sur la densité d'énergie radiante au point le plus brillant du plasma de conditionnement est inférieur à 0,5, éventuellement inférieur à 0,25, formant une surface conditionnée ; et
un traitement de conversion par plasma réalisé en traitant la surface conditionnée (si l'étape éventuelle est réalisée), ou la surface non conditionnée (si l'étape éventuelle est omise), avec un plasma de conversion ou de la vapeur d'eau, le plasma de conversion étant généré à un point éloigné de la surface conditionnée, où le ratio de la densité d'énergie radiante au point éloigné du traitement de conversion par plasma sur la densité d'énergie radiante au point le plus brillant du plasma de conversion est inférieur à 0,5, éventuellement inférieur à 0,25, dans lequel la densité d'énergie radiante au point le plus brillant du plasma est déterminée par spectrophotométrie en mesurant l'intensité radiante de la ligne d'émission la plus intense de la lumière dans le spectre des longueurs d'onde de 380 nm à 750 nm au point le plus brillant, et la densité d'énergie radiante au point éloigné est déterminée par spectrophotométrie en mesurant la densité d'énergie radiante de la même ligne d'émission de lumière au point éloigné,
pour former une surface convertie ayant un pourcentage de récupération de biomolécules, pour une dispersion aqueuse de protéines ayant une concentration de 0,01 nM à 1,4 nM, éventuellement 0,05 nM à 1,4 nM, éventuellement 0,1 nM à 1,4 nM, en contact avec la surface convertie, supérieure à 80 %, dans lequel le pourcentage de récupération de biomolécules est déterminé selon le procédé « Test de tous les modes de réalisation » décrit dans la description.

**2.** Procédé selon la revendication 1, dans lequel la surface est une surface de lumière d'un récipient.

**3.** Procédé selon une quelconque revendication précédente, dans lequel la surface convertie a un pourcentage de récupération de biomolécules supérieur au pourcentage de récupération de biomolécules de la surface non conditionnée et non convertie pour au moins une des protéines parmi :

l'albumine de sérum de mammifère ; l'albumine de sérum bovin (BSA) ; le fibrinogène (FBG) ; la transferrine (TFN) ; l'ovotransferrine de blanc d'œuf (conalbumine) ;
la mélanotransferrine associée à la membrane ; la protéine A (PrA) ; la protéine G (PrG) ; la protéine A/G ; la protéine L ; l'insuline ; une protéine pharmaceutique ; des protéines de composants du sang et une quelconque forme recombinante, une modification, un précurseur transcrit pleine longueur, un peptide de signal, un propeptide ou variant mature de ces protéines.

4. Procédé selon une quelconque revendication précédente, dans lequel la surface comprend un matériau thermoplastique.

5. Procédé selon une quelconque revendication précédente, dans lequel la surface comprend un polymère d'oléfine, du polypropylène (PP), du polyéthylène (PE), un copolymère d'oléfine cyclique (COC), un polymère d'oléfine cyclique (COP), du polyméthylpentène, un polyester, du polyéthylène téréphtalate, du polyéthylène naphtalate, du polybutylène téréphtalate (PBT), du chlorure de polyvinylidène (PVdC), du chlorure de polyvinyle (PVC), du polycarbonate, de l'acide polylactique, du polystyrène, du polystyrène hydrogéné, du polycyclohexyl éthylène (PCHE), une résine époxy, du nylon, du polyuréthane polyacrylonitrile, du polyacrylonitrile (PAN), une résine ionomérique un une combinaison quelconque, un composite ou un mélange de deux ou plusieurs quelconques de ces matériaux.

6. Procédé selon une quelconque revendication précédente, dans lequel le traitement de conditionnement par plasma et/ou le traitement de conversion par plasma sont réalisés en utilisant un plasma excité par une fréquence extrêmement basse (ELF) de 3 à 30 Hz, une fréquence super basse (SLF) de 30 à 300 Hz, la voix ou une fréquence ultra basse (VF ou ULF) de 300 Hz à 3 kHz, une fréquence très basse (VLF) de 3 à 30 kHz, une fréquence basse (LF) de 30 à 300 kHz, une fréquence moyenne (MF) de 300 kHz à 3 MHz, une fréquence élevée (HF) de 3 à 30 MHz, une fréquence très élevée (VHF) de 30 à 300 MHz, une fréquence ultra élevée (UHF) de 300 MHz à 3 GHz, ou une combinaison quelconque de deux ou plusieurs d'entre elles.

7. Procédé selon une quelconque revendication précédente, dans lequel la surface est un revêtement ou une couche de PECVD déposée sur un $SiO_xC_yH_z$ ou un $SiN_xC_yH_z$, dans lequel x est égal à environ 0,5 à environ 2,4 tel que mesuré par spectroscopie photo électronique de rayons X (XPS), y est égal à environ 0,6 à environ 3 tel que mesuré par XPS, et z est égal à environ 2 à environ 9 tel que mesuré par spectrométrie de rétrodiffusion de Rutherford (RBS) ; ou un revêtement ou une couche barrière de $SiO_x$, dans lequel x est égal à environ 1,5 à environ 2,9 tel que mesuré par XPS, ou un oxyde ou un nitrure fait à partir d'un précurseur organométallique qui est un composé d'un élément métallique du groupe III et/ou du groupe IV du tableau périodique, par exemple, dans le groupe III : du bore, de l'aluminium, du gallium, de l'indium, du thallium, du scandium, de yttrium ou du lanthane, (l'aluminium et le bore étant préférés), et dans le groupe IV : du silicium, du germanium, de l'étain, du plomb, du titane, du zirconium, de l'hafnium ou du thorium (le silicium et l'étain étant préférés).

8. Procédé selon une quelconque revendication précédente, dans lequel la surface est une surface de contact fluide d'un article de laboratoire, de préférence une microplaque, un tube de centrifugation, une pointe de pipette, un plateau de puits, un plateau de micropuits, un plateau ELISA, un plateau de microtitrage, un plateau de 96 puits, un plateau de 384 puits, un flacon, une bouteille, un bocal, une seringue, une cartouche, un emballage blister, une ampoule, un tube de collecte de sang évacué, un tube échantillon ou un flacon de chromatographie.

9. Procédé selon une quelconque revendication précédente, comprenant l'étape préliminaire de traitement de la surface avec le plasma de conditionnement, le plasma de conditionnement comprenant : un gaz contenant de l'azote, un gaz inerte, un gaz oxydant ou une combinaison de deux ou plusieurs parmi ceux-ci, formant la surface conditionnée.

10. Procédé selon une quelconque revendication précédente, comprenant en outre l'étape préliminaire de traitement de la surface avec du gaz ionisé comprenant : de l'air, de l'oxygène, un gaz inerte, un gaz contenant de l'azote, par exemple, de l'azote, de l'oxyde nitreux, du dioxyde d'azote, du tétroxyde d'azote, de l'ammoniac ou une combinaison de deux ou plusieurs quelconques d'entre eux.

11. Procédé selon l'une quelconque des revendications 1 à 9 comprenant les étapes : d'application de gaz ionisé sur la surface, et
de création du plasma de conditionnement à la surface, et de création du plasma de conversion à la surface.

12. Procédé selon la revendication 11, où le gaz ionisé est un quelconque gaz inerte, un quelconque gaz oxydant ou un quelconque gaz contenant de l'azote, et de préférence le gaz ionisé est de l'air.

13. Procédé selon la revendication 11 ou la revendication 12, où le plasma de conditionnement est de l'azote.

**14.** Article résultant du procédé selon l'une quelconque revendication précédente.

FIG. 1

FIG. 2

FIG. 3

% Protein Recovery
at 24 Hrs

FIG. 4

% Protein Recovery
at 24 Hrs

FIG. 5

FIG.6

FIG. 7

EP 3 289 007 B1

FIG. 8

FIG. 9

EP 3 289 007 B1

FIG. 10

FIG. 11

PrA at 24 Hours

FIG. 12

FIG. 13

FIG. 14

FIG. 15

PrG at 96 Hours : Recovery vs Conc

FIG. 16

FIG. 17

FIG. 18

FIG. 19

Isopropanol Blank

SiO2

Counts (%) vs. Acquisition Time (min)

FIG. 20

## Isopropanol Blank

## SiO2

Counts (%) vs. Acquisition Time (min)

# FIG. 21

Counts (%) vs. Acquisition Time (min)

FIG. 22

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5369012 A
- US 7985188 B

- WO 2013071138 A